# EUROPEAN PATENT APPLICATION

(11) **EP 4 608 114 A1**
(43) Date of publication of application: **27.08.2025**
(21) Application number: 23880224.3
(22) Date of filing: 18.10.2023
(51) Int. Cl.: H10K 77/10, H10K 50/844, H10K 59/40, G09F 9/30, G06F 1/16, H10K 59/121, H01L 27/12, H10K 71/00, H10K 102/00

(54) **DISPLAY DEVICE AND METHOD FOR MANUFACTURING SAME**

(30) Priority: 20.10.2022 KR 20220135734
(71) Applicant: Samsung Display Co., Ltd., Yongin-si, Gyeonggi-do 17113 (KR)
(72) Inventor: NAM, Dong Hun, Yongin-si, Gyeonggi-do 17113 (KR); LEE, Seong Jun, Yongin-si, Gyeonggi-do 17113 (KR); CHO, Hyun Jun, Yongin-si, Gyeonggi-do 17113 (KR)
(74) Representative: Dr. Weitzel & Partner
(86) International application number: PCT/KR2023/016156
(87) International publication number: WO 2024/085647

(57) **Abstract**

A display device includes a support member including a first non-folding part including a glass, a second non-folding part including the glass, and a folding part disposed between the first non-folding part and the second non-folding part, a circuit element layer disposed on the support member, and including at least one transistor, a light emitting element layer disposed on the circuit element layer, and including at least one light emitting diode; an encapsulation layer disposed on the light emitting element layer, and including at least one of an organic encapsulation layer and an inorganic encapsulation layer, a touch sensing layer disposed on the encapsulation layer, and including at least one touch electrode, a first adhesive layer disposed on the touch sensing layer, a cover window disposed on the first adhesive layer, a protective film disposed on the cover window, and a second adhesive layer disposed on the support member.

## Description

### [Technical Field]

The present invention generally relates to a display device. More particularly, the present invention relates to a foldable display device, which may be folded or unfolded, and a method for manufacturing the foldable display device.

### [Background Art]

Recently, a flexible display device that may be deformed into various shapes has been developed. Unlike a flat panel display device, the flexible display device may be folded, bent, or rolled like paper. The flexible display device may be easily carried, and may improve convenience of a user.

Recently, a foldable display device has been spotlighted among flexible display devices. The foldable display device may be repeatedly folded and unfolded. The foldable display device may include a display module having flexibility, and a support member disposed on a bottom surface of the display module. The support member may have relatively high rigidity, so that the support member may serve to prevent the display module from being deformed by a touch of the user and the like.

Conventionally, a metal has been used as a material for the support member. However, since the metal has a relatively large weight, when the support member includes the metal, a weight of the foldable display device may become relatively large. In addition, when the foldable display device is repeatedly folded and unfolded, permanent deformation may be applied to the support member, which may cause creases in the display module. Therefore, display quality of the display device may deteriorate.

### [Detailed Explanation of the Invention]

### [Technical Purpose]

One feature of the present invention is to provide a display device with improved display quality and improved durability.

Another feature of the present invention is to provide a method for manufacturing the display device.

However, the objects of the present invention are not limited to this object, and may be expanded in various ways without departing from the spirit and scope of the present invention.

### [Technical Solution]

According to an embodiment, a display device includes: a support member; a circuit element layer; a light emitting element layer; an encapsulation layer; a touch sensing layer; a first adhesive layer; a cover window; a protective film; and a second adhesive. The support member includes a first non-folding part including a glass, a second non-folding part including the glass, and a folding part disposed between the first non-folding part and the second non-folding part. The circuit element layer is disposed on the support member, and includes at least one transistor. The light emitting element layer is disposed on the circuit element layer, and includes at least one light emitting diode. The encapsulation layer is disposed on the light emitting element layer, and includes at least one of an organic encapsulation layer and an inorganic encapsulation layer. The touch sensing layer is disposed on the encapsulation layer, and includes at least one touch electrode. The first adhesive layer is disposed on the touch sensing layer. The cover window is disposed on the first adhesive layer. The protective film is disposed on the cover window. The second adhesive layer is disposed on the support member.

According to one embodiment, an opening may be defined in the folding part.

According to one embodiment, the display device may further include a filling material overlapping the folding part, and the filling material may fill the opening.

According to one embodiment, the filling material may be further disposed on the first non-folding part and the second non-folding part.

According to one embodiment, the display device may further include a metal member overlapping the folding part, and the metal member may fill the opening.

According to one embodiment, the metal member may include stainless steel.

According to one embodiment, an opening pattern may be defined in the folding part.

According to one embodiment, each of a plurality of openings included in the opening pattern may have one of a rectangular shape, a rhombic shape, an elliptical shape, a corrugated shape, and a rectangular shape with rounded corners.

According to one embodiment, the display device may further include a filling material overlapping the folding part, and the filling material may fill the opening pattern.

According to one embodiment, the filling material may be further disposed on the first non-folding part and the second non-folding part.

According to one embodiment, a groove may be defined in the folding part.

According to one embodiment, the display device may further include a filling material overlapping the folding part, and the filling material may fill the groove.

According to one embodiment, the filling material may be further disposed on the first non-folding part and the second non-folding part.

According to one embodiment, a thickness of the support member may be in a range of about 0.15 mm to about 0.2 mm.

According to one embodiment, the cover window may include ultra-thin tempered glass.

According to one embodiment, the display device may further include: a first base substrate disposed between the support member and the circuit element layer; a first barrier layer disposed on the first base substrate; and a second base substrate disposed on the first barrier layer.

According to one embodiment, each of the first base substrate and the second base substrate may include polyimide.

According to one embodiment, the first barrier layer may include silicon oxide.

According to one embodiment, a thickness of each of the first base substrate and the second base substrate may be in a range of about 56,000 angstroms to about 100,000 angstroms.

According to one embodiment, the circuit element layer may include: a first active layer disposed on the support member; and a second active layer disposed on the first active layer.

According to one embodiment, the first active layer may include a silicon semiconductor, and the second active layer may include an oxide semiconductor.

According to one embodiment, the display device may further include a metal plate disposed on the second adhesive layer.

According to one embodiment, the display device may further include a digitizer disposed on the second adhesive layer.

According to one embodiment, the first non-folding part may further include a first pattern that is adjacent to the folding part, and the second non-folding part may further include a second pattern that is adjacent to the folding part.

According to one embodiment, the support member may include a first surface that is adjacent to the circuit element layer, and a second surface that is opposite to the first surface, and each of the first pattern and the second pattern may be defined on the second surface of the support member.

According to one embodiment, a height of each of the first pattern and the second pattern may be smaller than a height of the folding part, and a width of each of the first pattern and the second pattern may be smaller than a width of the folding part.

According to one embodiment, each of the first pattern and the second pattern may include an opening pattern or a groove.

According to one embodiment, the circuit element layer may include a barrier layer disposed on the support member and making contact with the support member.

According to one embodiment, the barrier layer may include silicon oxide.

According to an embodiment, a method for manufacturing a display device includes forming a preliminary support member including a glass. A circuit element layer is formed on the preliminary support member. A light emitting element layer is formed on the circuit element layer. An encapsulation layer is formed on the light emitting element layer. A touch sensing layer is formed on the encapsulation layer. A support member is formed by forming a folding part by patterning a portion of the preliminary support member, and forming a first non-folding part and a second non-folding part, which are adjacent to each other with the folding part interposed between the first non-folding part and the second non-folding part, by thinning the entire preliminary support member. A first adhesive layer is formed on the touch sensing layer. A cover window is formed on the first adhesive layer. A protective film is formed on the cover window. A second adhesive layer is formed on the support member.

According to one embodiment, the preliminary support member may include a first surface that is adjacent to the circuit element layer, and a second surface that is opposite to the first surface, and the thinning of the preliminary support member may include thinning the second surface of the preliminary support member.

According to one embodiment, the forming of the support member may be performed after the forming of the touch sensing layer.

According to one embodiment, the forming of the support member may include: attaching a first acid-resistant film onto the touch sensing layer; attaching a second acid-resistant film under the preliminary support member; patterning a portion of the second acid-resistant film overlapping the folding part; primarily etching the preliminary support member; removing the second acid-resistant film; secondarily etching the preliminary support member; and removing the first acid-resistant film.

According to one embodiment, the primarily etching of the preliminary support member may include partially etching a portion of the folding part overlapping the patterned portion of the second acid-resistant film.

According to one embodiment, the secondarily etching of the preliminary support member may include forming the support member by etching the entire preliminary support member.

According to one embodiment, a thickness of the folding part after the secondarily etching may be smaller than a thickness of the folding part after the primarily etching.

According to one embodiment, a thickness of each of the first non-folding part and the second non-folding part after the secondarily etching may be smaller than a thickness of each of the first non-folding part and the second non-folding part after the primarily etching.

According to one embodiment, the forming of the folding part may include forming an opening in the folding part.

According to one embodiment, the forming of the folding part may include forming an opening pattern in the folding part.

According to one embodiment, the forming of the folding part may include forming a groove in the folding part.

According to one embodiment, the method for manufacturing the display device may further include filling the folding part with a filling material.

According to one embodiment, the filling material may be further formed under the first non-folding part and the second non-folding part.

According to one embodiment, the method for manufacturing the display device may further include forming a metal member in the folding part.

According to one embodiment, the metal member may be formed of stainless steel.

According to one embodiment, a thickness of the preliminary support member may be in a range of about 0.4 mm to about 0.5 mm.

According to one embodiment, a thickness of each of the first non-folding part and the second non-folding part included in the support member may be in a range of about 0.15 mm to about 0.2 mm.

According to one embodiment, before the forming of the circuit element layer, the method for manufacturing the display device may further include: forming a first base substrate on the preliminary support member; forming a first barrier layer on the first base substrate; and forming a second base substrate on the first barrier layer.

According to one embodiment, each of the first base substrate and the second base substrate may be formed of polyimide.

According to one embodiment, the first barrier layer may be formed of silicon oxide.

According to one embodiment, the method for manufacturing the display device may further include forming a metal plate under the second adhesive layer.

According to one embodiment, the method for manufacturing the display device may further include forming a digitizer under the second adhesive layer.

According to one embodiment, the forming of the support member may include: forming a first pattern, which is adjacent to the folding part, in the first non-folding part; and forming a second pattern, which is adjacent to the folding part, in the second non-folding part.

According to one embodiment, the forming of the circuit element layer may include forming a barrier layer making contact with the preliminary support member on the preliminary support member.

### [Advantageous Effects]

According to the display device of the embodiments of the present invention, a support member may include glass, and a filling material overlapping a folding part may fill an opening in the folding part, so that creases can be prevented from being generated in the folding part, and thus durability can be improved. Since the support member includes glass, a weight of a product can be reduced. In addition, since the support member includes glass, impact resistance can be improved.

According to the method for manufacturing the display device of the embodiments of the present invention, a support member may be formed by a primary etching process and a secondary etching process on a preliminary support member, and a circuit element layer may be directly formed on the support member. Therefore, a carrier substrate to be removed during a manufacturing process of the display device can be prevented from being separately required, so that the manufacturing process of the display device can be simplified. In addition, the preliminary support member may be thinned, so that a thickness of the display device can be reduced.

However, the effects of the present invention are not limited to the above effects, and may be expanded in various ways without departing from the spirit and scope of the present invention.

### [Brief Description of the Drawings]

FIG. 1 is a perspective view showing a state in which a display device according to one embodiment of the present invention is unfolded.
FIG. 2 is a sectional view showing a state in which the display device of FIG. 1 is folded.
FIG. 3 is a sectional view taken along a line I-I' of FIG. 1.
FIG. 4 is a sectional view showing only a support member, a filling material, and a display panel of FIG. 3.
FIG. 5 is an enlarged view showing a portion of FIG. 4.
FIG. 6 is a sectional view showing only the display panel and the support member of FIG. 3.
FIG. 7 is a sectional view showing another example of FIG. 6.
FIG. 8 is a sectional view showing still another example of FIG. 6.
FIG. 9 is a sectional view showing yet another example of FIG. 6.
FIG. 10 is a sectional view showing still yet another example of FIG. 6.
FIGS. 11, 12, 13, and 14 are plan views showing the support member of FIG. 10.
FIG. 15 is a sectional view showing another example of FIG. 10.
FIG. 16 is a sectional view showing still another example of FIG. 10.
FIG. 17 is a sectional view showing another example of FIG. 6.
FIG. 18 is a sectional view showing another example of FIG. 17.
FIG. 19 is a sectional view showing still another example of FIG. 17.
FIG. 20 is a sectional view showing another example of FIG. 5.
FIG. 21 is a sectional view showing another example of FIG. 3.
FIG. 22 is a sectional view showing still another example of FIG. 3.
FIGS. 23, 24, 25, 26, 27, 28, 29, 30, 31, 32, 33, 34, 35, 36, 37, 38, 39, 40, and 41 are views showing a method for manufacturing a display device according to one embodiment of the present invention.
FIG. 42 is a sectional view showing a method for manufacturing a display device according to an embodiment of the present invention.
FIG. 43 is a sectional view showing another example of FIG. 42.
FIG. 44 is a sectional view showing another example of FIG. 37.
FIG. 45 is a sectional view showing still another example of FIG. 37.
FIGS. 46 and 47 are sectional views showing another example of FIGS. 36 and 37.
FIGS. 48 and 49 are sectional views showing still another example of FIGS. 36 and 37.
FIG. 50 is a sectional view showing another example of FIG. 36.
FIG. 51 is a sectional view showing another example of FIG. 46.
FIG. 52 is a sectional view showing another example of FIG. 48.
FIGS. 53, 54, 55, 56, and 57 are views for describing a method for manufacturing a display device according to an embodiment of the present invention.

### [Best Mode]

### [Mode for Invention]

Hereinafter, embodiments of the present invention will be described in more detail with reference to the accompanying drawings. The same reference numerals are used for the same components in the drawings, and redundant descriptions of the same components may not be provided.

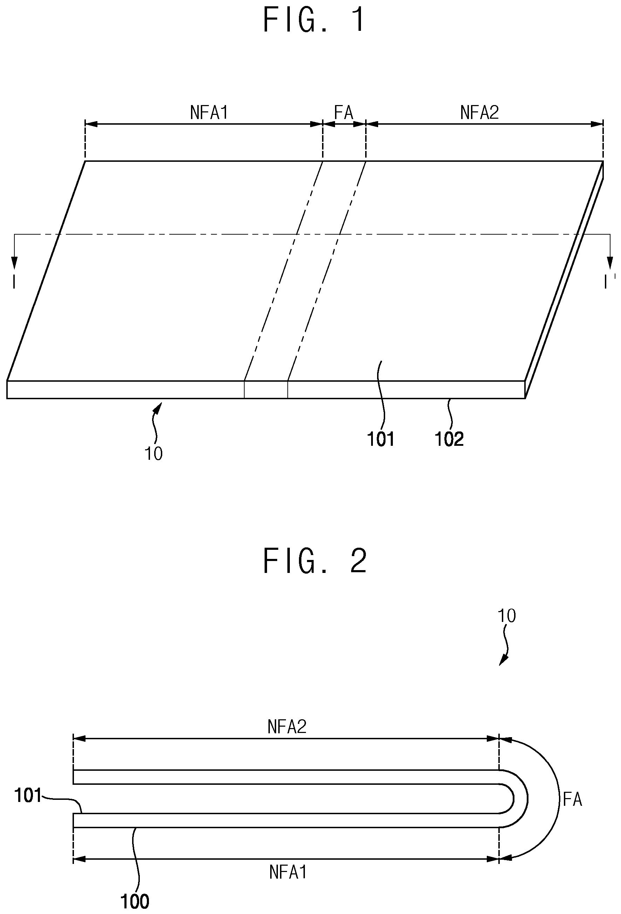

FIG. 1 is a perspective view showing a state in which a display device 10 according to one embodiment of the present invention is unfolded. FIG. 2 is a sectional view showing a state in which the display device 10 of FIG. 1 is folded.

Referring to FIGS. 1 and 2, the display device 10 may include a display surface 101 and a non-display surface 102 that is opposite to the display surface 101. The display surface 101 may be a surface on which an image is displayed in the display device 10. The non-display surface 102 may be a surface on which the image is not displayed in the display device 10. According to one embodiment, the image may also be displayed on the non-display surface 102. For example, the image may be displayed on a portion of the non-display surface 102. Alternatively, the image may be displayed on the entire non-display surface 102.

The display device 10 may have a stacked structure. For example, the display device 10 may include a plurality of layers having mutually different functions. Each of the layers may have flexibility, so that the display device 10 may have flexibility.

The display device 10 may include a first non-folding area NFA1, a second non-folding area NFA2, and a folding area FA located between the first non-folding area NFA1 and the second non-folding area NFA2.

The display device 10 may not be folded in the first and second non-folding areas NFA1 and NFA2. The display device 10 may have a flat surface in the first and second non-folding areas NFA1 and NFA2.

The display device 10 may be folded and unfolded in the folding area FA. The display device 10 may be folded, e.g., a folded state of FIG. 2, or unfolded, e.g., an unfolded state of FIG. 1, in the folding area FA. In addition, the display device 10 may be in-folded or out-folded. For example, the display device 10 may be in-folded such that display surfaces 101 of the display device 10 may face each other. However, according to an embodiment, the display device 10 may be out-folded such that non-display surfaces 102 of the display device 10 may face each other.

In an embodiment, the display device 10 may further include a third non-folding area that is adjacent to the second non-folding area NFA2. In addition, the display device 10 may further include a folding area located between the second non-folding area NFA2 and the third non-folding area. In addition, according to an embodiment, a width of the folding area FA may be wide. Therefore, the display device 10 may slide in the folding area FA, so that an area of the display surface 101 may be adjusted.

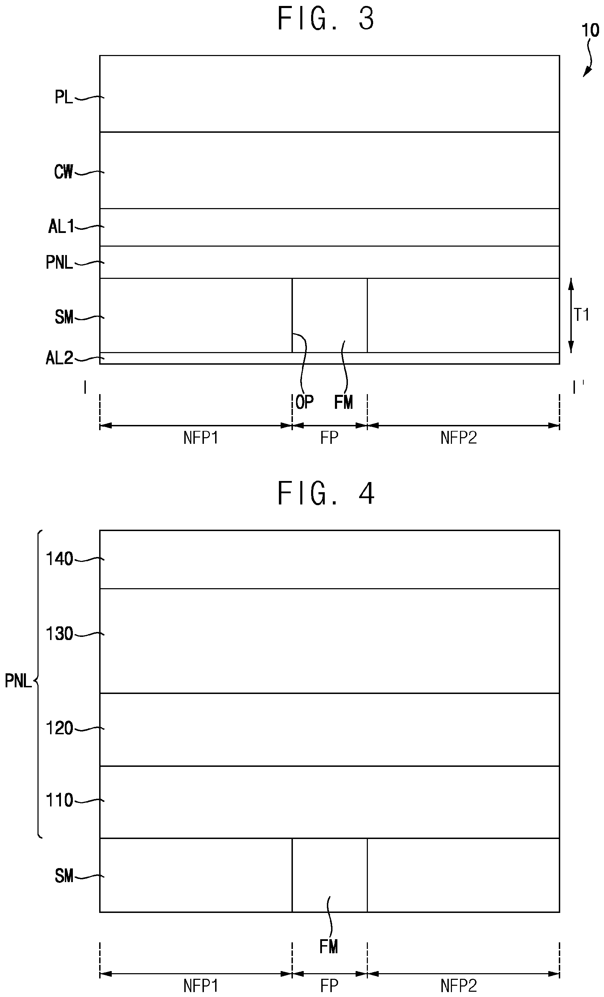

FIG. 3 is a sectional view taken along a line I-I' of FIG. 1. FIG. 4 is a sectional view showing only a support member SM, a filling material FM, and a display panel PNL of FIG. 3.

Referring further to FIG. 3, the display device 10 may include the support member SM, the filling material FM, the display panel PNL, a first adhesive layer AL1, a cover window CW, a protective film PL, and a second adhesive layer AL2. Since the display device 10 may be folded or unfolded as described above, each of the support member SM, the filling material FM, the display panel PNL, the first adhesive layer AL1, the cover window CW, the protective film PL, and the second adhesive layer AL2 may have flexibility.

The support member SM may support the display panel PNL, and may emit or disperse heat generated from the display panel PNL. In addition, the support member SM may prevent foreign substances from being introduced into the display panel PNL from an outside.

The support member SM may include a first non-folding part NFP1, a second non-folding part NFP2, and a folding part FP. The folding part FP may be disposed between the first non-folding part NFP1 and the second non-folding part NFP2. The first non-folding part NFP1 may overlap the first non-folding area NFA1, the second non-folding part NFP2 may overlap the second non-folding area NFA2, and the folding part FP may overlap the folding area FA.

Each of the first non-folding part NFP1 and the second non-folding part NFP2 may include glass, e.g., a separate glass pieces.

An opening OP may be defined in the folding part FP. The filling material FM may overlap the folding part FP, and may fill the opening OP.

A thickness of the support member SM may be in a range of about 0.15 T (i.e., 0.15 mm) to about 0.2 T (i.e., 0.2 mm). In detail, a thickness T1 of each of the first non-folding part NFP1 and the second non-folding part NFP2 may be in the range of about 0.15 T (i.e., 0.15 mm) to about 0.2 T (i.e., 0.2 mm).

In a case where the thickness T1 of each of the first non-folding part NFP1 and the second non-folding part NFP2 is smaller than about 0.15 T (i.e., 0.15 mm), each of the first non-folding part NFP1 and the second non-folding part NFP2 may be fragile. Therefore, durability of the support member SM may deteriorate.

In addition, in a case where the thickness T1 of each of the first non-folding part NFP1 and the second non-folding part NFP2 is greater than about 0.2 T (i.e., 0.2 mm), when the filling material FM fills the folding part FP, the filling material FM may not uniformly fill the folding part FP. Therefore, filling reliability of the filling material FM may deteriorate.

The display panel PNL may be disposed on the support member SM. The display panel PNL may include a plurality of pixels, and an image may be generated by combining lights emitted from the pixels, respectively.

Referring further to FIG. 4, the display panel PNL may include a circuit element layer 110, a light emitting element layer 120, an encapsulation layer 130, and a touch sensing layer 140.

The circuit element layer 110 may be disposed on the support member SM. The circuit element layer 110 may include insulating layers and conductive layers. The circuit element layer 110 may include at least one transistor. The light emitting element layer 120 may be formed on the circuit element layer 110. The light emitting element layer 120 may include at least one light emitting diode. The light emitting element layer 120 may emit a light, and the circuit element layer 110 may drive the light emitting element layer 120.

The encapsulation layer 130 may be disposed on the light emitting element layer 120. The encapsulation layer 130 may prevent moisture and oxygen from penetrating into the light emitting diode from the outside. The encapsulation layer 130 may include at least one of an organic encapsulation layer and an inorganic encapsulation layer.

The touch sensing layer 140 may be disposed on the encapsulation layer 130. The touch sensing layer 140 may include at least one touch electrode.

Referring again to FIG. 3, the first adhesive layer AL1 may be disposed on the display panel PNL. In detail, the first adhesive layer AL1 may be disposed on the touch sensing layer 140.

The cover window CW may be disposed on the first adhesive layer AL1. The cover window CW may serve to protect the display panel PNL. The cover window CW may be formed of a transparent material. The cover window CW may be coupled to the display panel PNL through the first adhesive layer AL1.

For example, the cover window CW may include ultra-thin film tempered glass (Ultra-Thin Glass; UTG). The ultra-thin film tempered glass may be strengthened to have a predetermined stress profile therein. The strengthened ultra-thin film tempered glass may be more resistant to crack generation due to an external impact, crack propagation, damage, and the like as compared with the ultra-thin film tempered glass before the strengthening. The ultra-thin film tempered glass strengthened through a strengthening process may have various stresses for each region.

When glass is configured as an ultra-thin film or a thin film, the glass may have flexibility so as to have a curvable, bendable, foldable, or rollable characteristic. Glass of the cover window CW may include soda lime glass, alkali aluminosilicate glass, borosilicate glass, or lithium alumina silicate glass. The ultra-thin film tempered glass of the cover window CW may be thin film glass that is chemically strengthened to have high strength. However, in an embodiment, the ultra-thin film tempered glass of the cover window CW may be thin film glass that is thermally strengthened.

The protective film PL may be disposed on the cover window CW. The protective film PL may perform at least one of a scattering prevention function, a shock absorption function, a dent prevention function, a fingerprint prevention function, and a glare prevention function for the cover window CW. The protective film PL may include a transparent polymer film. The transparent polymer film may include at least one of an epoxy resin, polyurethane, polyester, polyethylene terephthalate, polyethylene naphthalate, polyimide, polyarylate, polycarbonate, polymethyl methacrylate, ethyl vinyl acetate, and a polyamide resin.

The second adhesive layer AL2 may be disposed under the support member SM. The second adhesive layer AL2 may couple the support member SM to a lower module disposed under the support member SM.

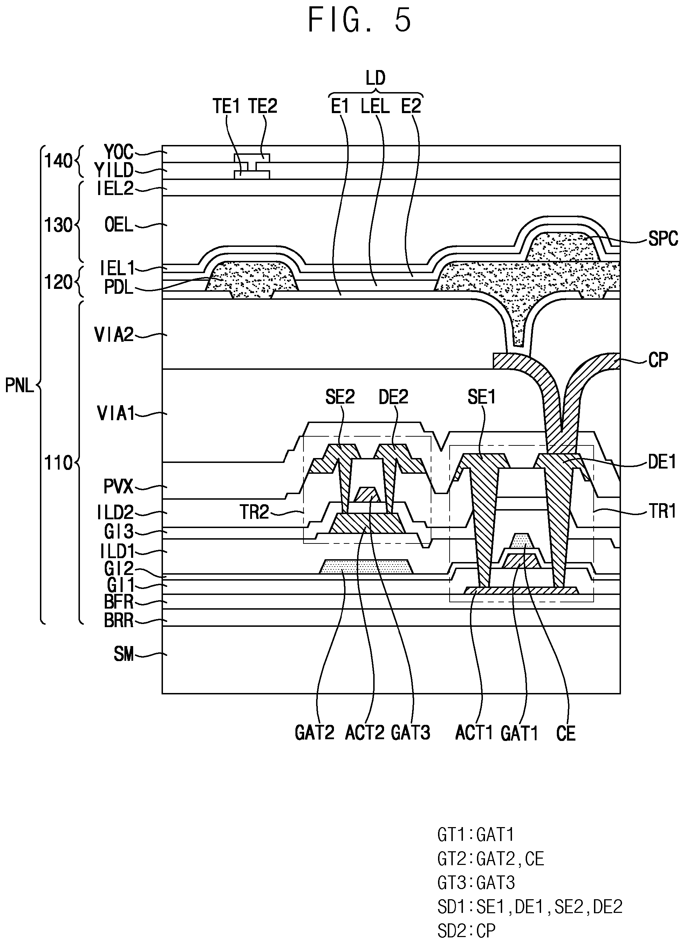

FIG. 5 is an enlarged view showing a portion of FIG. 4.

Referring further to FIG. 5, the circuit element layer 110 may be disposed on the support member SM. The circuit element layer 110 may include a barrier layer BRR, a buffer layer BFR, a plurality of insulating layers, a first active layer ACT1, a first gate layer GT1, a second gate layer GT2, a second active layer ACT2, a third gate layer GT3, a first conductive layer SD1, and a second conductive layer SD2.

The barrier layer BRR may be disposed on the support member SM. The barrier layer BRR may make contact with the support member SM. The barrier layer BRR may prevent moisture from penetrating from the outside. For example, the barrier layer BRR may include silicon oxide. In addition, the barrier layer BRR may have a thickness of about 5,000 angstroms.

The buffer layer BFR may be disposed on the barrier layer BRR. The buffer layer BFR may prevent metal atoms or impurities from diffusing from the support member SM. For example, the buffer layer BFR may be configured as a double layer. One layer may include silicon oxide, and may have a thickness of about 3,000 angstroms. Another layer may include silicon nitride, and may have a thickness of about 500 angstroms. However, in an embodiment, the buffer layer BFR may be configured as one layer or a double or more layer.

The first active layer ACT1 may be disposed on the buffer layer BFR. The first active layer ACT1 may be divided into source and drain regions doped with impurities and a channel region disposed between the source region and the drain region. For example, the first active layer ACT1 may include a silicon semiconductor.

A first gate insulating layer GI1 may be disposed on the buffer layer BFR to cover the first active layer ACT1. The first gate insulating layer GI1 may include an inorganic material. For example, the first gate insulating layer GI1 may include silicon oxide.

The first gate layer GT1 may be disposed on the first gate insulating layer GI1. The first gate layer GT1 may include a first gate electrode GAT1. The first gate electrode GAT1 may overlap the channel region of the first active layer ACT1.

A second gate insulating layer GI2 may be disposed on the first gate insulating layer GI1 to cover the first gate layer GT1. The second gate insulating layer GI2 may include an inorganic material. For example, the second gate insulating layer GI2 may include silicon nitride.

The second gate layer GT2 may be disposed on the second gate insulating layer GI2. The second gate layer GT2 may include a capacitor electrode CE and a second gate electrode GAT2. The capacitor electrode CE may overlap the first gate electrode GAT1. The capacitor electrode CE and the first gate electrode GAT1 may constitute a first storage capacitor. The second gate electrode GAT2 may be spaced apart from the capacitor electrode CE.

A first interlayer insulating layer ILD1 may be disposed on the second gate insulating layer GI2 to cover the second gate layer GT2. The first interlayer insulating layer ILD1 may be configured as a double layer. One layer may include silicon oxide, and another layer may include silicon nitride. However, in an embodiment, the first interlayer insulating layer ILD1 may be configured as one layer or a double or more layer.

The second active layer ACT2 may be disposed on the first interlayer insulating layer ILD1. The second active layer ACT2 may be divided into source and drain regions doped with impurities and a channel region disposed between the source region and the drain region. For example, the second active layer ACT2 may include an oxide semiconductor. In other words, the second active layer ACT2 may include a material that is different from the material of the first active layer ACT1. However, in an embodiment, the second active layer ACT2 may include the same material as the first active layer ACT1.

A third gate insulating layer GI3 may be disposed on the first interlayer insulating layer ILD1 to cover the second active layer ACT2. The third gate insulating layer GI3 may include an inorganic material. For example, the third gate insulating layer GI3 may include silicon oxide.

The third gate layer GT3 may be disposed on the third gate insulating layer GI3. The third gate layer GT3 may include a third gate electrode GAT3. The third gate electrode GAT3 may overlap the channel region of the second active layer ACT2. The third gate electrode GAT3 may overlap the second gate electrode GAT2. The third gate electrode GAT3 and the second gate electrode GAT2 may constitute a second storage capacitor.

A second interlayer insulating layer ILD2 may be disposed on the third gate insulating layer GI3 to cover the third gate layer GT3. The second interlayer insulating layer ILD2 may be configured as a double layer. One layer may include silicon oxide, and another layer may include silicon nitride. However, in an embodiment, the second interlayer insulating layer ILD2 may be configured as one layer or a double or more layer.

The first conductive layer SD1 may be disposed on the second interlayer insulating layer ILD2. The first conductive layer SD1 may include a first source electrode SE1, a first drain electrode DE1, a second source electrode SE2, and a second drain electrode DE2. The first source electrode SE1 and the first drain electrode DE1 may be connected to the first active layer ACT1. The second source electrode SE2 and the second drain electrode DE2 may be connected to the second active layer ACT2.

The first active layer ACT1, the first gate electrode GAT1, the first source electrode SE1, and the first drain electrode DE1 may constitute a first transistor TR1. The second active layer ACT2, the third gate electrode GAT3, the second source electrode SE2, and the second drain electrode DE2 may constitute a second transistor TR2.

A passivation layer PVX may be disposed on the second interlayer insulating layer ILD2 to cover the first conductive layer SD1. The passivation layer PVX may include an inorganic material. For example, the passivation layer PVX may include silicon nitride.

A first via insulating layer VIA1 may be disposed on the passivation layer PVX. The first via insulating layer VIA1 may include an organic material. For example, the first via insulating layer VIA1 may include polyimide. The first via insulating layer VIA1 may planarize a top surface of a stacked structure.

The second conductive layer SD2 may be disposed on the first via insulating layer VIA1. The second conductive layer SD2 may include a connection electrode CP. The connection electrode CP may make contact with the first drain electrode DE1 of the first transistor TR1. The connection electrode CP may connect a light emitting diode LD to the first transistor TR1.

A second via insulating layer VIA2 may be disposed on the first via insulating layer VIA1. The second via insulating layer VIA2 may include an organic material. For example, the second via insulating layer VIA2 may include polyimide. The second via insulating layer VIA2 may planarize a top surface of the stacked structure.

The light emitting element layer 120 may be disposed on the circuit element layer 110. The light emitting element layer 120 may include at least one light emitting diode LD and a pixel defining layer PDL. The light emitting diode LD may include a first electrode E1, a light emitting layer LEL, and a second electrode E2.

The first electrode E1 may be disposed on the second via insulating layer VIA2. The first electrode E1 may make contact with the connection electrode CP. The first electrode E1 may be connected to the first transistor TR1 through the connection electrode CP.

The pixel defining layer PDL may be disposed on the second via insulating layer VIA2. An opening extending to and exposing a top surface of the first electrode E1 may be disposed in the pixel defining layer PDL. The pixel defining layer PDL may include an organic material or an inorganic material. For example, the pixel defining layer PDL may include polyimide.

A spacer SPC may be disposed on the pixel defining layer PDL. The spacer SPC may include an organic material or an inorganic material. The spacer SPC may maintain a gap between the encapsulation layer 130 and the support member SM.

The spacer SPC may include an organic material or an inorganic material. The spacer SPC may include the same material as the pixel defining layer PDL. For example, the pixel defining layer PDL and the spacer SPC may include an organic material such as polyimide. In addition, the pixel defining layer PDL and the spacer SPC may be simultaneously formed by using a halftone mask. However, in an embodiment, the spacer SPC may be formed of a material that is different from the material of the pixel defining layer PDL. The spacer SPC may be formed after the pixel defining layer PDL is formed.

The light emitting layer LEL may be disposed on the first electrode E1. The light emitting layer LEL may be disposed in the opening formed in the pixel defining layer PDL. According to one embodiment, the light emitting layer LEL may have a multilayer structure including a hole injection layer, a hole transport layer, an organic light emitting layer, an electron transport layer, and an electron injection layer. The organic light emitting layer may include a light emitting material.

The second electrode E2 may be disposed on the pixel defining layer PDL and the spacer SPC to cover the light emitting layer LEL. According to one embodiment, the second electrode E2 may have a plate shape. In addition, the second electrode E2 may have a light-transmitting or reflective characteristic. For example, the second electrode E2 may include a metal.

The encapsulation layer 130 may be disposed on the light emitting element layer 120. The encapsulation layer 130 may prevent moisture and oxygen from penetrating into the light emitting diode LD from the outside. For example, the encapsulation layer 130 may include a first inorganic encapsulation layer IEL1, an organic encapsulation layer OEL, and a second inorganic encapsulation layer IEL2.

The first inorganic encapsulation layer IEL1 may be formed on the second electrode E2 along a profile of the second electrode E2 with a substantially uniform thickness. The organic encapsulation layer OEL may be formed on the first inorganic encapsulation layer IEL1, and may have a substantially flat top surface without creating a step around the first inorganic encapsulation layer IEL1. The second inorganic encapsulation layer IEL2 may be formed on the organic encapsulation layer OEL.

The touch sensing layer 140 may be disposed on the encapsulation layer 130. The touch sensing layer 140 may include a first touch electrode TE1, a touch insulating layer YILD, a second touch electrode TE2, and a touch planarization layer YOC.

The touch insulating layer YILD may be disposed on the first touch electrode TE1, the second touch electrode TE2 may be disposed on the touch insulating layer YILD, and the touch planarization layer YOC may be disposed on the second touch electrode TE2. The touch planarization layer YOC may have a substantially flat top surface. The touch planarization layer YOC may be substantially parallel to a top surface of the light emitting diode LD. The second touch electrode TE2 may be connected to the first touch electrode TE1 through a contact hole in the touch insulating layer YILD. The touch sensing layer 140 may function as an input device of the display device 10.

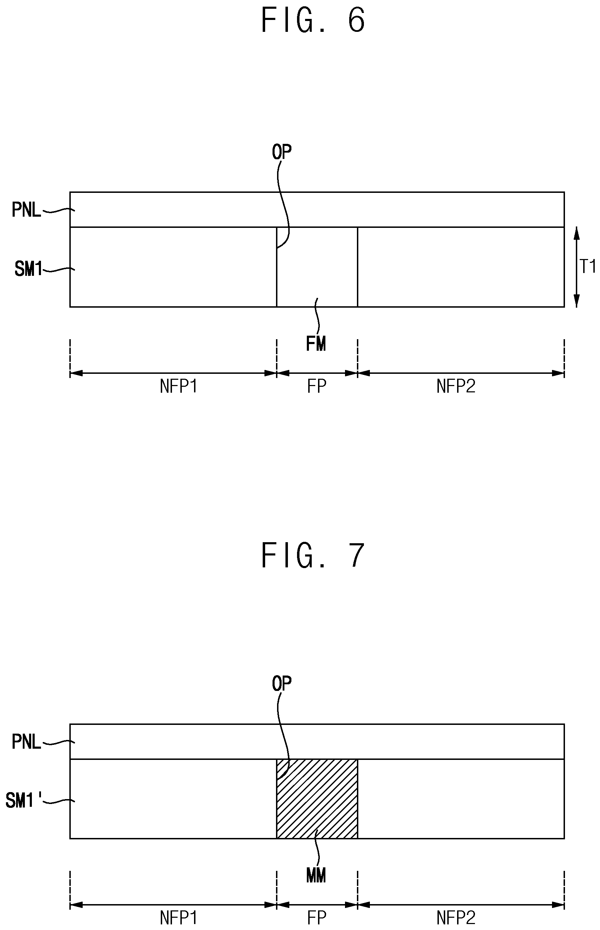

FIG. 6 is a sectional view showing only the display panel and the support member of or similar to FIG. 3.

Referring to FIGS. 4 and 6, a support member SM1 may include the first non-folding part NFP1, the second non-folding part NFP2, and the folding part FP. The first non-folding part NFP1 and the second non-folding part NFP2 may include glass. An opening OP may be defined in the folding part FP. The filling material FM overlapping the folding part FP may be disposed in the folding part FP. The filling material FM may fill the opening OP.

The filling material FM may include a silicon-based resin. In addition, the filling of the filling material FM may be performed by a screen printing scheme, a molding scheme, or the like.

The thickness T1 of each of the first non-folding part NFP1 and the second non-folding part NFP2 may be in the range of about 0.15 T (i.e., 0.15 mm) to about 0.2 T (i.e., 0.2 mm). Therefore, the filling material FM may uniformly fill the folding part FP, and a folding characteristic of the folding part FP may be improved.

According to one embodiment, the support member SM1 may include glass, and the filling material FM overlapping the folding part FP may fill the opening OP, so that creases may be prevented from being generated in the folding part FP, and thus durability may be improved. Since the support member SM1 includes glass, a weight of a product may be reduced. In addition, since the support member SM1 includes glass, impact resistance may be improved.

FIG. 7 is a sectional view showing another example of FIG. 6.

Referring to FIG. 7, a metal member MM overlapping the folding part FP may be disposed in a folding part FP included in a support member SM1'. The metal member MM may fill the opening OP of the folding part FP. The metal member MM may include a metal. For example, the metal member MM may include stainless steel.

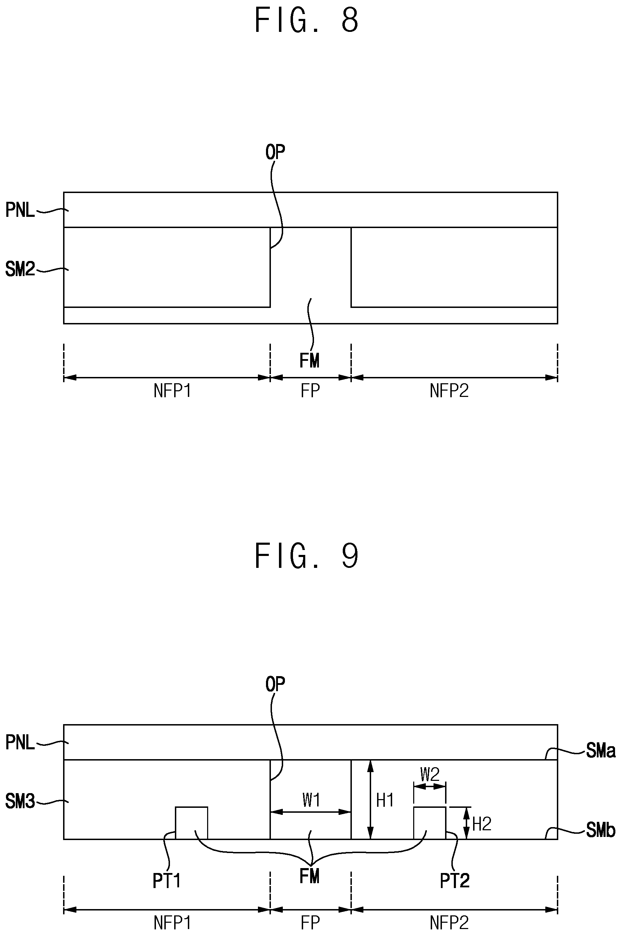

FIG. 8 is a sectional view showing still another example of FIG. 6.

Referring to FIG. 8, the filling material FM may be disposed in an opening OP of a folding part FP included in a support member SM2, and may be further disposed under the first non-folding part NFP1 and the second non-folding part NFP2. In other words, the filling material FM may overlap all of the first non-folding part NFP1, the second non-folding part NFP2, and the folding part FP.

Since the filling material FM is disposed even under the support member SM2, visibility of a boundary between the folding part FP and the first non-folding part NFP1 and a boundary between the folding part FP and the second non-folding part NFP2 may be minimized. Therefore, display quality may be improved.

FIG. 9 is a sectional view showing yet another example of FIG. 6.

Referring to FIG. 9, the first non-folding part NFP1 may further include a first pattern PT1. The second non-folding part NFP2 may further include a second pattern PT2. Each of the first pattern PT1 and the second pattern PT2 may be adjacent to the folding part FP. Each of the first pattern PT1 and the second pattern PT2 may be an inverse curvature part having an inverse curvature that is opposite to a curvature of the folding part FP.

A support member SM3 may include a first surface SMa and a second surface SMb. The first surface SMa may be a surface that is adjacent to the display panel PNL, e.g., the circuit element layer 110, and the second surface SMb may be a surface that is opposite to the first surface SMa. Each of the first pattern PT1 and the second pattern PT2 may be defined on the second surface SMb of the support member SM3. Each of the first pattern PT1 and the second pattern PT2 may include a groove. In other words, each of the first pattern PT1 and the second pattern PT2 may have a groove shape.

A height H2 of each of the first pattern PT1 and the second pattern PT2 may be smaller than a height H1 of the folding part FP. A width W2 of each of the first pattern PT1 and the second pattern PT2 may be smaller than a width W1 of the folding part FP. Therefore, the opening OP of the folding part FP may be formed through the support member SM3, whereas each of the first pattern PT1 and the second pattern PT2 may be a groove, which is not formed through the support member SM3.

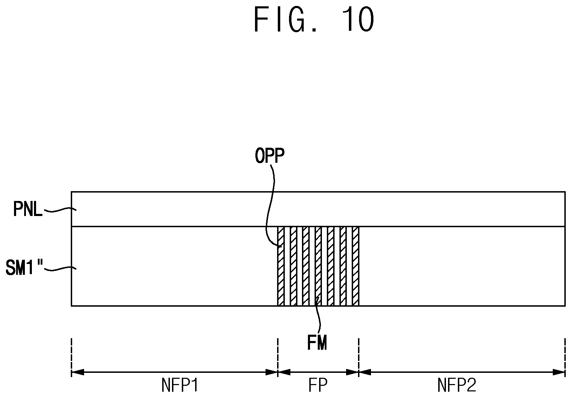

FIG. 10 is a sectional view showing still yet another example of FIG. 6.

Redundant descriptions of a support member SM1", which will be described with reference to FIG. 10, corresponding to the support member SM1 described with reference to FIG. 6 will be omitted.

Referring to FIG. 10, the support member SM1" may include the first non-folding part NFP1, the second non-folding part NFP2, and the folding part FP. The first non-folding part NFP1 and the second non-folding part NFP2 may include glass. An opening pattern OPP may be defined in the folding part FP. The filling material FM overlapping the folding part FP may be disposed in the folding part FP. The filling material FM may fill the opening pattern OPP.

According to one embodiment, the support member SM1" may include glass, and the filling material FM overlapping the folding part FP may fill the opening pattern OPP, so that creases may be prevented from being generated in the folding part FP. In addition, since the support member SM1" includes glass, a weight of a product may be reduced.

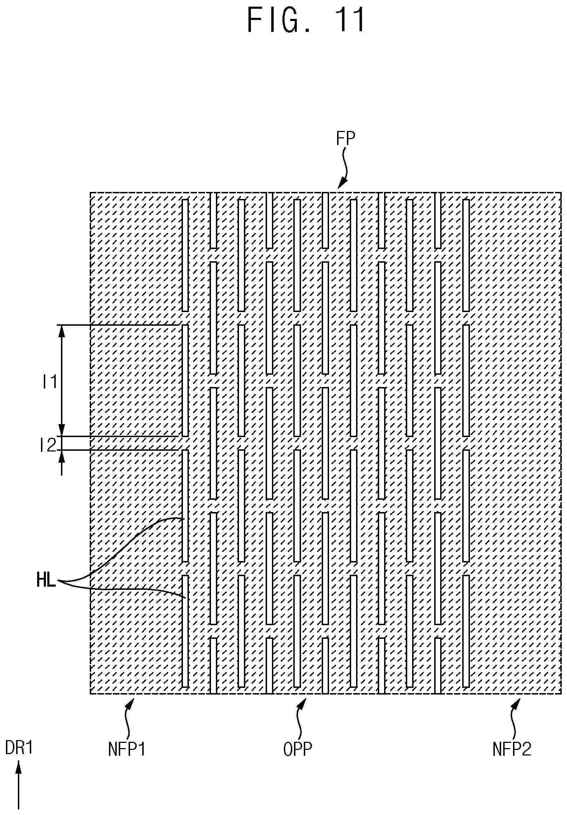

FIGS. 11 to 14 are plan views showing the support member of FIG. 10.

Referring further to FIGS. 11 to 14, the opening pattern OPP may include a plurality of openings HL. Each of the openings HL may have one of a rectangular shape, a rhombic shape, an elliptical shape, a corrugated shape, and a rectangular shape with rounded corners. The opening pattern OPP may be formed by removing a portion of the support member SM1".

Referring to FIG. 11, according to one embodiment, the opening pattern OPP of the folding part FP may include the openings HL. The openings HL may have the same shape. In detail, the openings HL may have the same rectangular shape. Each of the openings HL may have a shape extending in a first direction DR1. In other words, a long axis of each of the openings HL may be parallel to the first direction DR1. The rectangular shape may have a specific length l1, and the rectangular shapes may be spaced apart from each other by a specific interval l2 on the same line. The rectangular shapes arranged in the same column may be aligned or misaligned with the rectangular shapes arranged in an adjacent column.

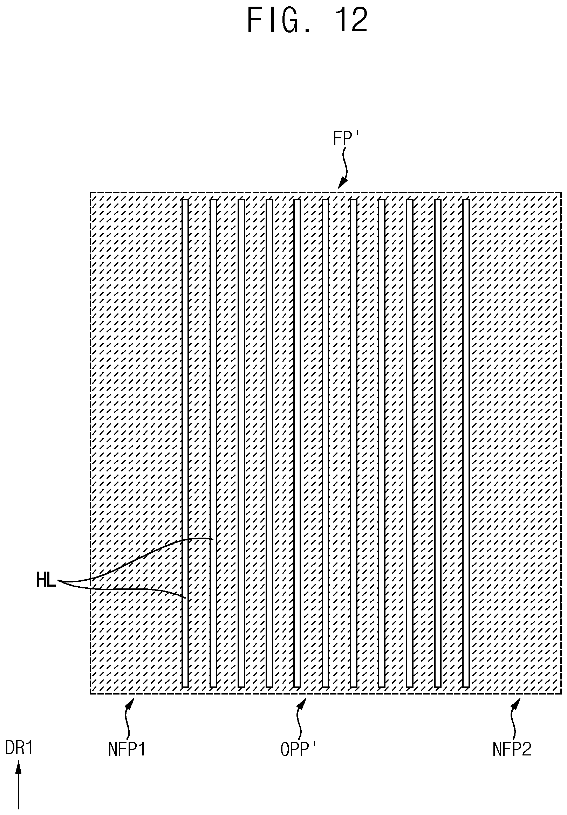

Referring to FIG. 12, an opening pattern OPP' of a folding part FP' may include openings HL. The openings HL may have the same shape. In detail, the openings HL may have the same rectangular shape, and each of the openings HL may have a shape extending in the first direction DR1. The opening pattern OPP' of the folding part FP' may be configured such that only one opening extending in the first direction DR1 is disposed in the same column.

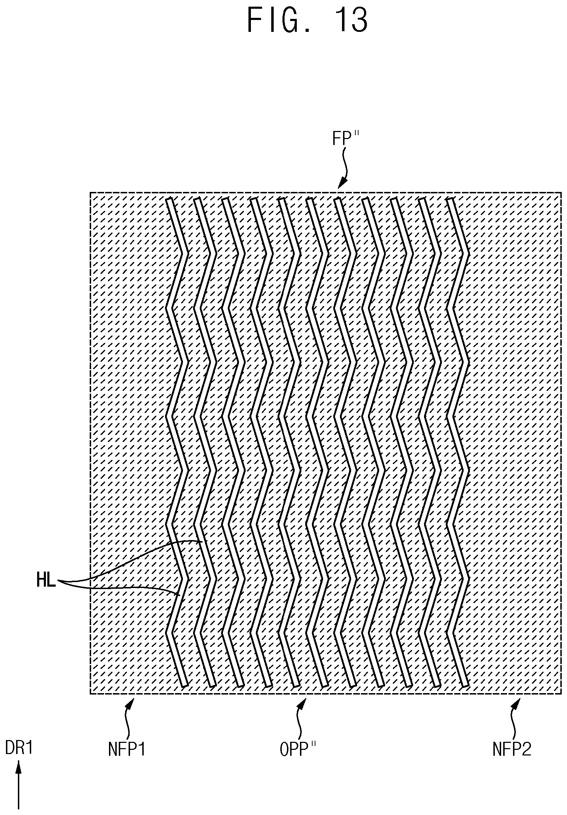

Referring to FIG. 13, an opening pattern OPP" of a folding part FP" may include openings HL. Each of the openings HL may have a corrugated shape. The opening pattern OPP'' may be configured such that only one opening extending in the first direction DR1 is disposed.

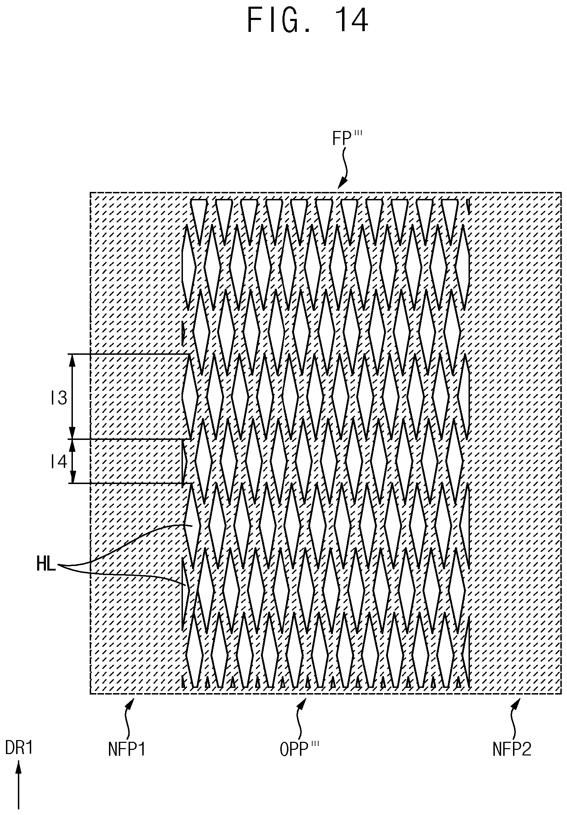

Referring to FIG. 14, an opening pattern OPP‴ of a folding part FP‴ may include openings HL. Each of the openings HL may have a rhombic shape. The rhombic shape may have a specific length l3, and the rhombic shapes may be spaced apart from each other by a specific interval l4 on the same line. The rhombic shapes arranged in the same column may be aligned or misaligned with the rhombic shapes arranged in an adjacent column.

However, according to an embodiment, shapes or sizes of the openings HL may be different from each other. In addition, according to an embodiment, the openings HL may have a rectangular shape with rounded corners, an elliptical shape, and the like in addition to the above shapes.

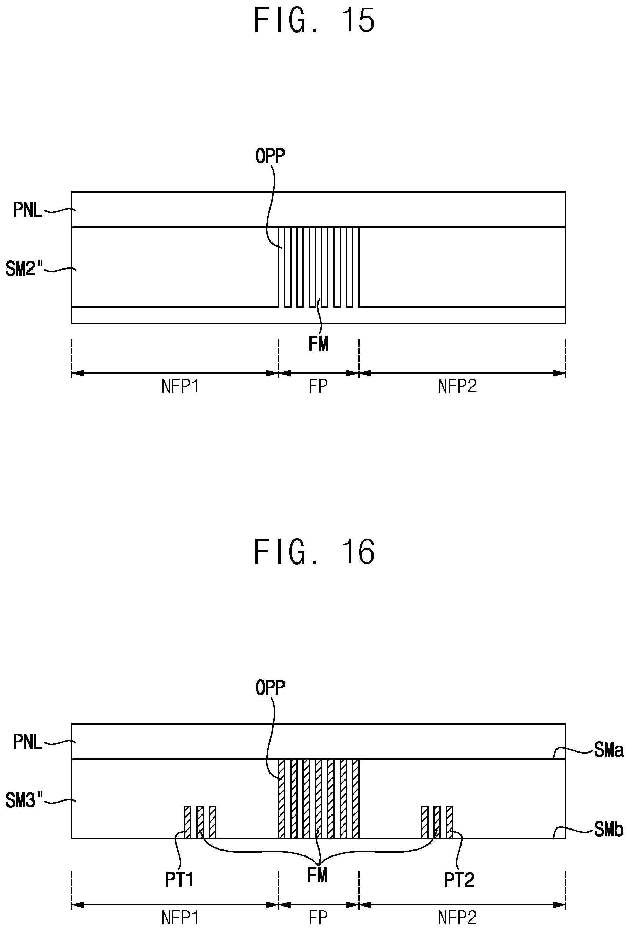

FIG. 15 is a sectional view showing another example of FIG. 10.

Referring to FIG. 15, the filling material FM may be disposed in the opening OPP of the folding part FP, and may be further disposed under the first non-folding part NFP1 and the second non-folding part NFP2. In other words, the filling material FM may overlap all of the first non-folding part NFP1, the second non-folding part NFP2, and the folding part FP.

Since the filling material FM is disposed even under a support member SM2'', visibility of a boundary between the folding part FP and the first non-folding part NFP1 and a boundary between the folding part FP and the second non-folding part NFP2 may be minimized. Therefore, display quality can be improved.

FIG. 16 is a sectional view showing still another example of FIG. 10.

Referring to FIG. 16, the first non-folding part NFP1 may further include a first pattern PT1. The second non-folding part NFP2 may further include a second pattern PT2. Each of the first pattern PT1 and the second pattern PT2 may be adjacent to the folding part FP.

A support member SM3'' may include a first surface SMa and a second surface SMb. Each of the first pattern PT1 and the second pattern PT2 may be defined on the second surface SMb of the support member SM3". Each of the first pattern PT1 and the second pattern PT2 may include an opening pattern. In other words, each of the first pattern PT1 and the second pattern PT2 may have an opening pattern shape.

A height of each of the first pattern PT1 and the second pattern PT2 may be smaller than a height of the folding part FP. A width of each of the first pattern PT1 and the second pattern PT2 may be smaller than a width of the folding part FP. Therefore, the opening pattern OPP of the folding part FP may be formed through the support member SM3", whereas each of the first pattern PT1 and the second pattern PT2 may not be formed through the support member SM3".

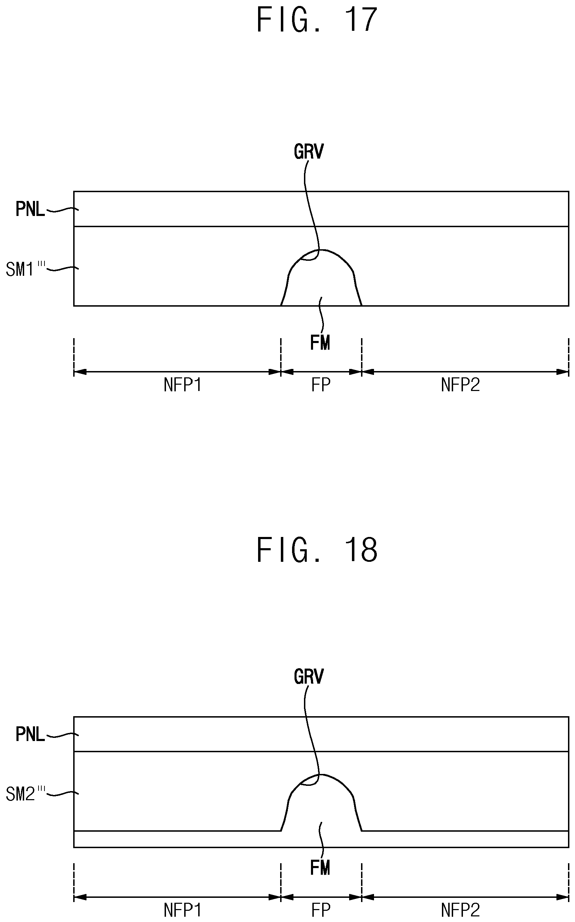

FIG. 17 is a sectional view showing another example of FIG. 6.

Redundant descriptions of a support member SM1‴, which will be described with reference to FIG. 17, corresponding to the support member SM1 described with reference to FIG. 6 will be omitted.

Referring to FIG. 17, the support member SM1‴ may include the first non-folding part NFP1, the second non-folding part NFP2, and the folding part FP. The first non-folding part NFP1 and the second non-folding part NFP2 may include glass. A groove GRV may be defined in the folding part FP. The filling material FM overlapping the folding part FP may be disposed in the folding part FP. The filling material FM may fill the groove GRV.

According to one embodiment, the support member SM1‴ may include glass, and the filling material FM overlapping the folding part FP may fill the groove GRV, so that creases may be prevented from being generated in the folding part FP. In addition, since the support member SM1‴ includes glass, a weight of a product may be reduced.

FIG. 18 is a sectional view showing another example of FIG. 17.

Referring to FIG. 18, the filling material FM may be disposed in the opening OP of the folding part FP, and may be further disposed under the first non-folding part NFP1 and the second non-folding part NFP2. In other words, the filling material FM may overlap all of the first non-folding part NFP1, the second non-folding part NFP2, and the folding part FP.

Since the filling material FM is disposed even under a support member SM2‴, visibility of a boundary between the folding part FP and the first non-folding part NFP1 and a boundary between the folding part FP and the second non-folding part NFP2 may be minimized. Therefore, display quality may be improved.

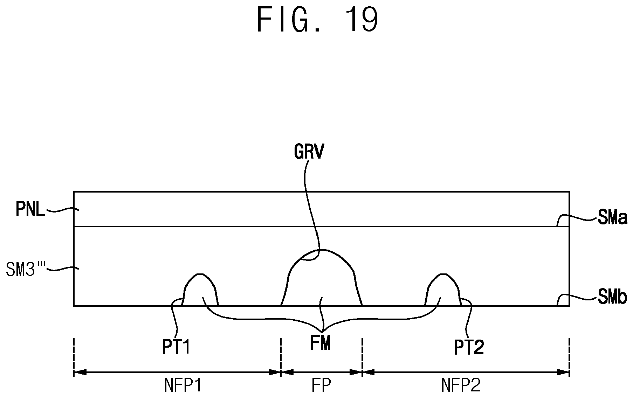

FIG. 19 is a sectional view showing still another example of FIG. 17.

Referring to FIG. 19, the first non-folding part NFP1 may further include a first pattern PT1. The second non-folding part NFP2 may further include a second pattern PT2. Each of the first pattern PT1 and the second pattern PT2 may be adjacent to the folding part FP. Each of the first pattern PT1 and the second pattern PT2 may be defined on a second surface SMb of a support member SM3‴.

Each of the first pattern PT1 and the second pattern PT2 may include a groove. In other words, each of the first pattern PT1 and the second pattern PT2 may have a groove shape.

A height of each of the first pattern PT1 and the second pattern PT2 may be smaller than a height of the folding part FP. A width of each of the first pattern PT1 and the second pattern PT2 may be smaller than a width of the folding part FP. Therefore, the groove GRV of the folding part FP and each of the first pattern PT1 and the second pattern PT2 may not be formed through the support member SM3‴.

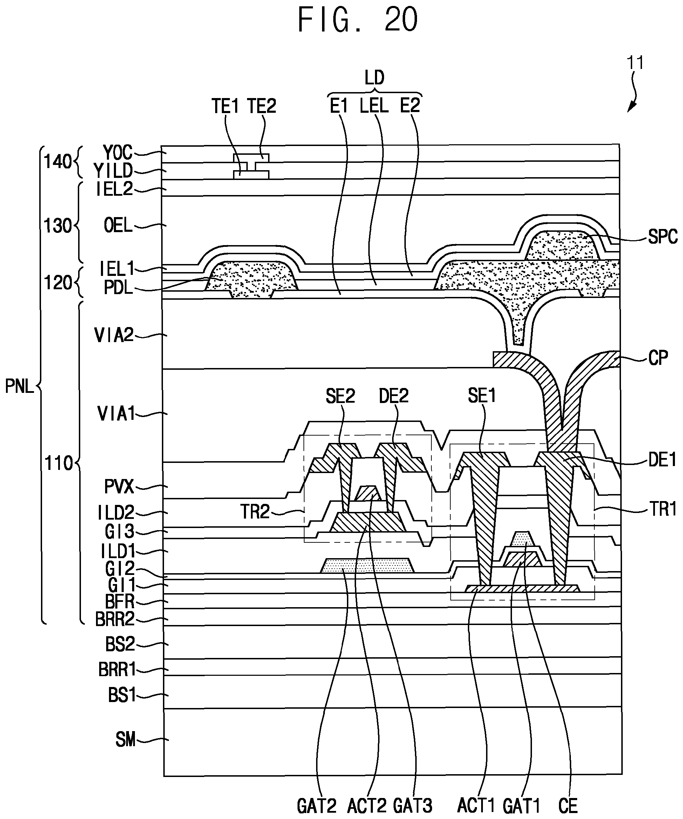

FIG. 20 is a sectional view showing another example of FIG. 5.

Referring to FIG. 20, a display device 11 may further include a first base substrate BS1, a first barrier layer BRR1, and a second base substrate BS2.

The first base substrate BS1, the first barrier layer BRR1, and the second base substrate BS2 may be disposed between the support member SM and the circuit element layer 110. The first base substrate BS1, the first barrier layer BRR1, and the second base substrate BS2 may prevent moisture from penetrating from the outside. The first base substrate BS1 and the second base substrate BS2 may be configured as a double layer in order to delay a moisture penetration time.

In detail, the first base substrate BS1 may be disposed between the support member SM and the circuit element layer 110. The first barrier layer BRR1 may be disposed on the first base substrate BS1. The second base substrate BS2 may be disposed on the first barrier layer BRR1. A second barrier layer BRR2, e.g., the barrier layer BRR of FIG. 5, may be disposed on the second base substrate BS2.

For example, each of the first base substrate BS1 and the second base substrate BS2 may include polyimide. A thickness of each of the first base substrate BS1 and the second base substrate BS2 may be in a range of about 56,000 angstroms to about 100,000 angstroms. When the thickness of each of the first base substrate BS1 and the second base substrate BS2 is smaller than about 56,000 angstroms, an effect of preventing the moisture from penetrating from the outside may deteriorate. In addition, when the thickness of each of the first base substrate BS1 and the second base substrate BS2 is greater than about 100,000 angstroms, a manufacturing time may be increased so that process efficiency may deteriorate, and a folding characteristic may deteriorate.

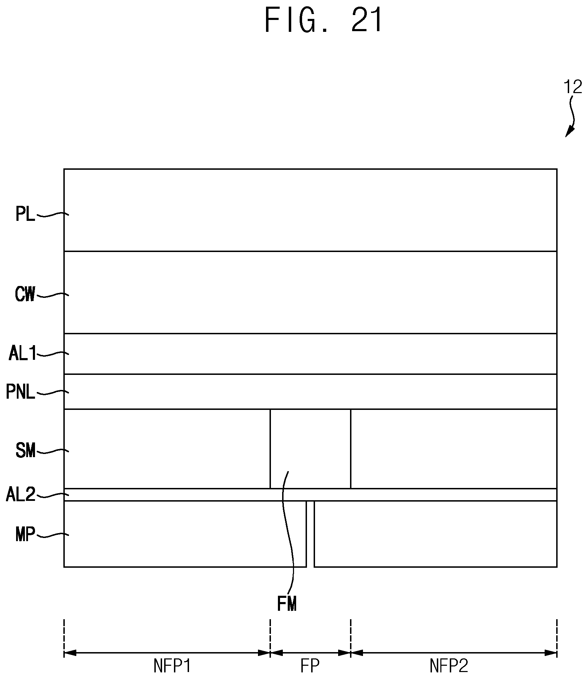

FIG. 21 is a sectional view showing another example of FIG. 3.

Redundant descriptions of a display device 12, which will be described with reference to FIG. 21, corresponding to the display device 10 described with reference to FIG. 3 will be omitted.

Referring to FIG. 21, the display device 12 may further include a metal plate MP. The metal plate MP may be disposed under the second adhesive layer AL2. The metal plate MP may be attached to the support member SM through the second adhesive layer AL2.

The metal plate MP may include two sub-plates separated from each other. Therefore, even when the folding part FP is folded, the metal plate MP may not be damaged.

The metal plate MP may support the support member SM. Since the display device 12 further includes the metal plate MP, durability of the display device 12 may be improved.

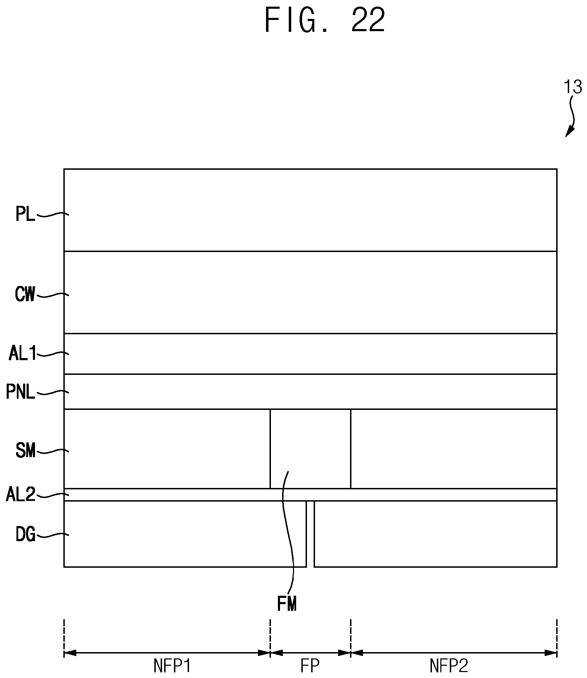

FIG. 22 is a sectional view showing still another example of FIG. 3.

Redundant descriptions of a display device 13, which will be described with reference to FIG. 22, corresponding to the display device 10 described with reference to FIG. 3 will be omitted.

Referring to FIG. 22, the display device 13 may further include a digitizer DG. The digitizer DG may be disposed under the second adhesive layer AL2. The digitizer DG may be attached to the support member SM through the second adhesive layer AL2.

The digitizer DG may recognize location information on a display surface of the display device 13 indicated by a user by using an input apparatus. Accordingly, the display device 13 may provide an input device to the user through the digitizer DG. The digitizer DG may recognize a movement of the input apparatus, e.g., a stylus pen, on the display surface of the display device 13, and convert the movement of the input apparatus into a digital signal.

The digitizer DG may include two sub-digitizers separated from each other. Therefore, even when the folding part FP is folded, the digitizer DG may not be damaged.

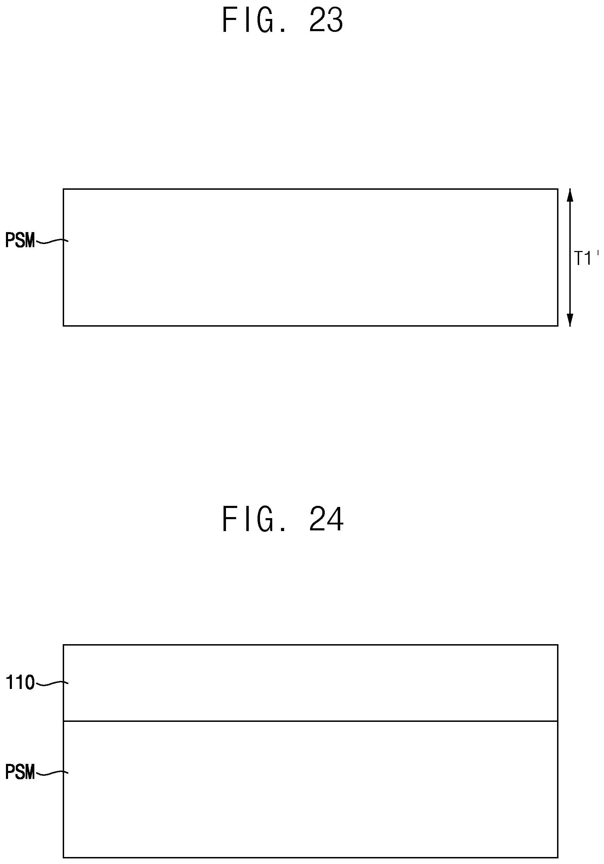

FIGS. 23 to 41 are views showing a method for manufacturing a display device according to one embodiment of the present invention.

For example, a method for manufacturing a display device that will be described with reference to FIGS. 23 to 41 may be a method for manufacturing the display device 10 of FIG. 3.

Referring to FIG. 23, a preliminary support member PSM may be formed. The preliminary support member PSM may include glass. In addition, a thickness T1' of the preliminary support member PSM may be in a range of about 0.4 T (i.e., 0.4 mm) to about 0.5 T (i.e., 0.5 mm).

Referring to FIG. 24, a circuit element layer 110 may be formed on the preliminary support member PSM. In other words, at least one transistor may be formed on the preliminary support member PSM.

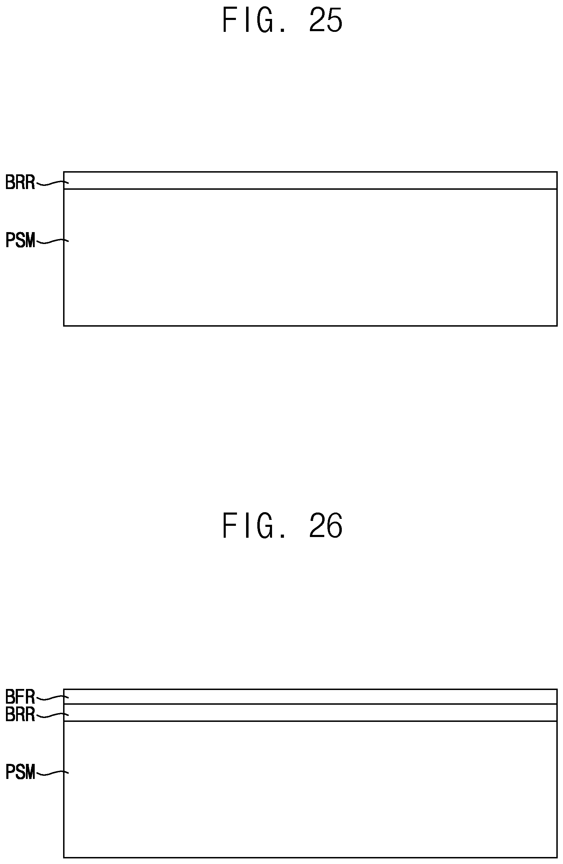

FIGS. 25 to 27 are enlarged views showing a portion of FIG. 24.

Referring to FIG. 25, in detail, a barrier layer BRR making contact with the preliminary support member PSM may be formed on the preliminary support member PSM. The barrier layer BRR may be formed of silicon oxide.

Referring to FIG. 26, a buffer layer BFR may be formed on the barrier layer BRR. The buffer layer BFR may be configured as a double layer. One layer may be formed of silicon oxide, and another layer may be formed of silicon nitride.

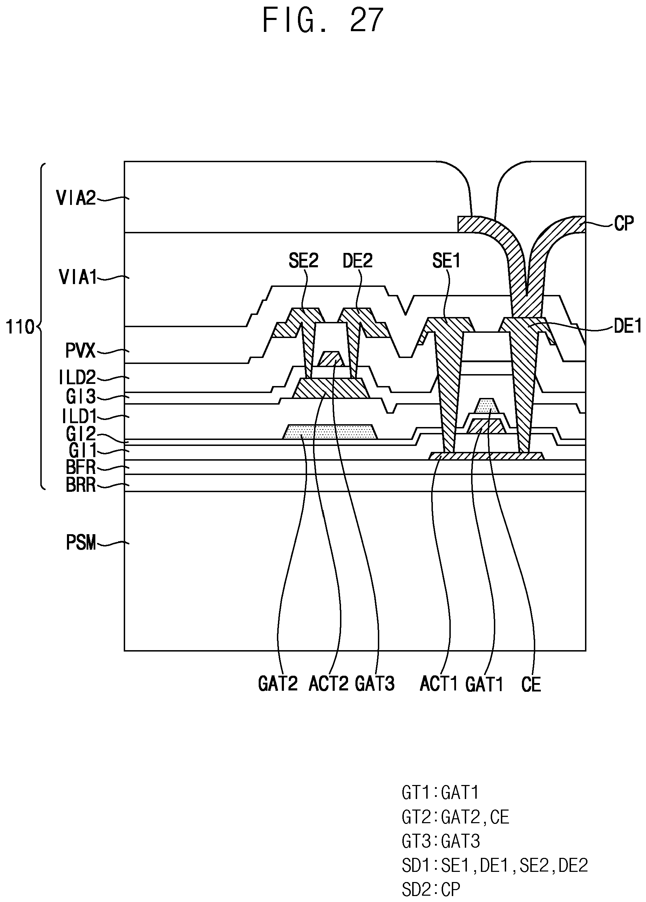

Referring to FIG. 27, a plurality of insulating layers, a first active layer ACT1, a first gate layer GT1, a second gate layer GT2, a second active layer ACT2, a third gate layer GT3, a first conductive layer SD1, and a second conductive layer SD2 may be formed on the buffer layer BFR.

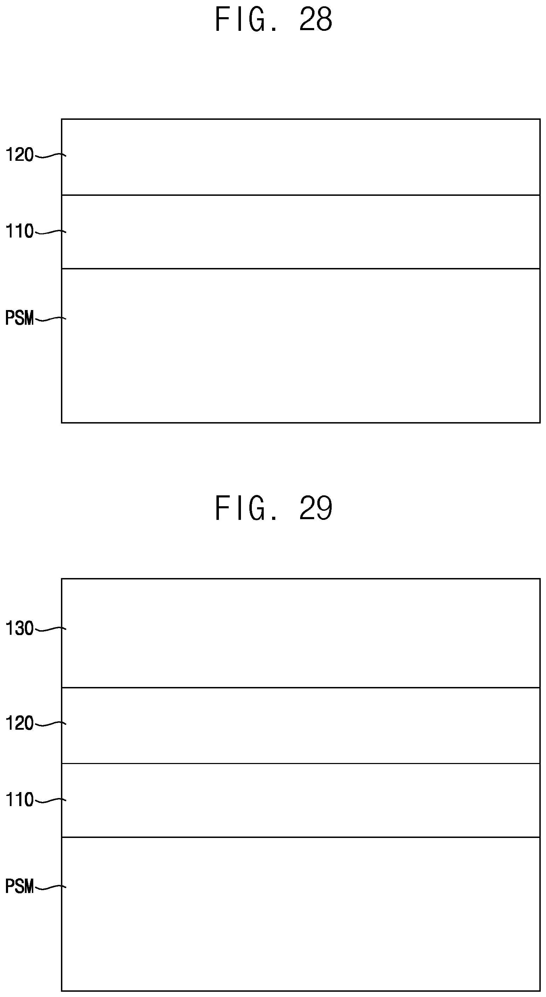

Referring to FIG. 28, a light emitting element layer 120 may be formed on the circuit element layer 110. In other words, at least one light emitting diode, e.g., the light emitting diode LD of FIG. 5, may be formed on the circuit element layer 110.

Referring to FIG. 29, an encapsulation layer 130 may be formed on the light emitting element layer 120. In other words, at least one of an organic encapsulation layer and an inorganic encapsulation layer may be formed on the light emitting element layer 120.

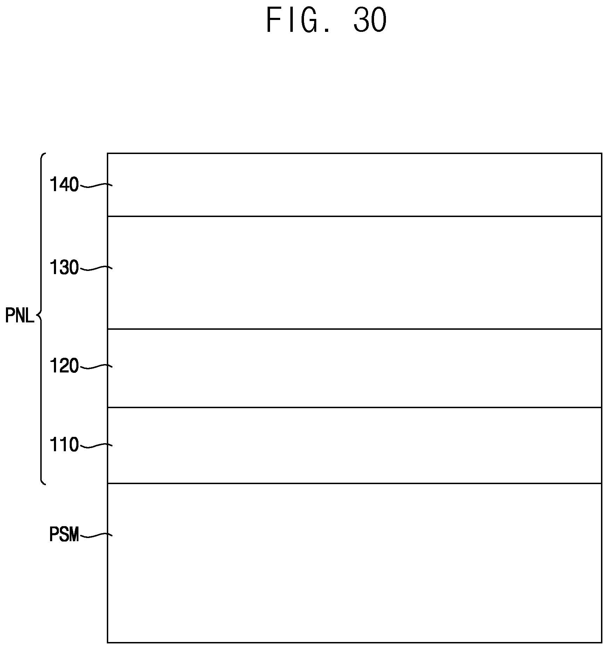

Referring to FIG. 30, a touch sensing layer 140 may be formed on the encapsulation layer 130. In other words, at least one touch electrode may be formed on the encapsulation layer 130. Therefore, a display panel PNL may be formed from the circuit element layer 110 to the touch sensing layer 140.

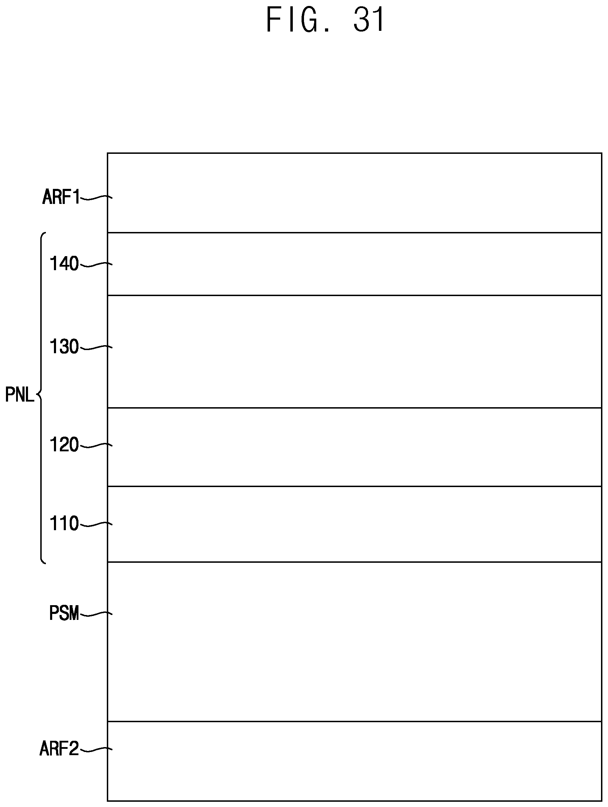

Referring to FIGS. 31 to 35, after the touch sensing layer 140 is formed, a support member SM may be formed from the preliminary support member PSM. In other words, a portion of the preliminary support member PSM may be patterned to form a folding part FP. The entire preliminary support member PSM may be slimmed, i.e., thinned or reduced in thickness, to form a first non-folding part NFP1 and a second non-folding part NFP2, which are adjacent to each other with the folding part FP interposed between the first non-folding part NFP1 and the second non-folding part NFP2.

Referring to FIG. 31, in detail, a first acid-resistant film ARF1 may be attached onto the touch sensing layer 140. A second acid-resistant film ARF2 may be attached under the preliminary support member PSM.

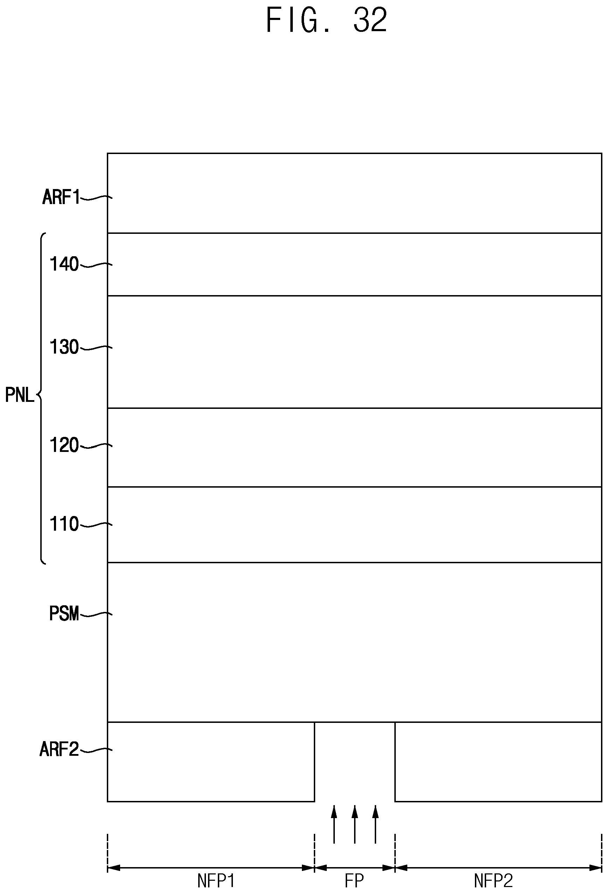

Referring further to FIG. 32, a portion of the second acid-resistant film ARF2 overlapping the folding part FP may be patterned, e.g., removed.

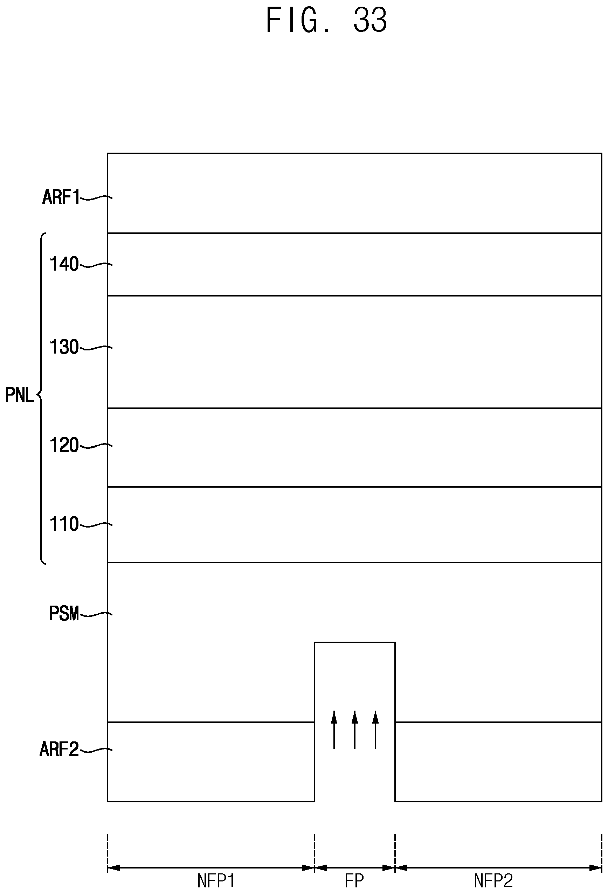

Referring further to FIGS. 33 to 36, the preliminary support member PSM may be etched through primary and secondary etching processes.

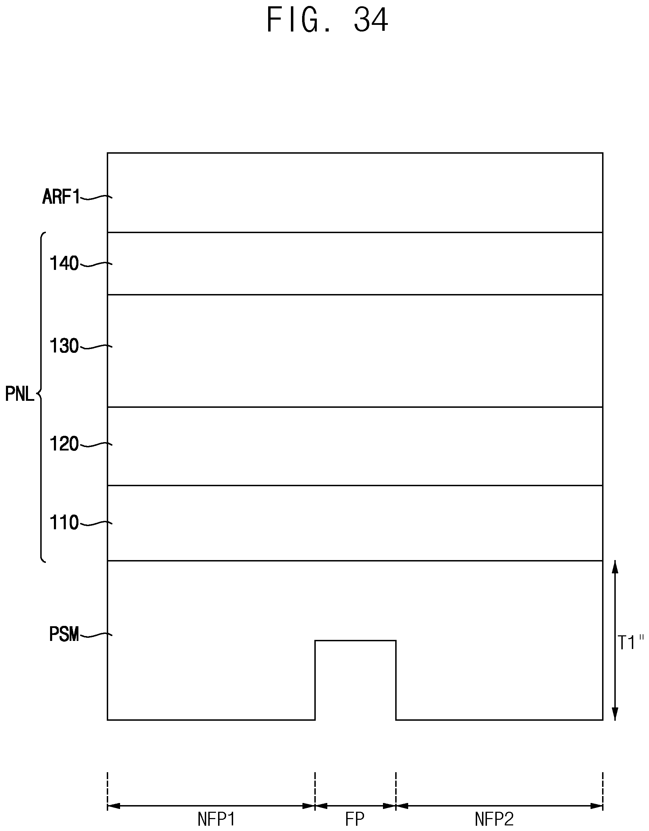

Referring to FIGS. 33 and 34, the preliminary support member PSM may be primarily etched. When the primary etching is performed, a portion of the folding part FP overlapping the patterned portion of the second acid-resistant film ARF2 may be partially etched. Therefore, the folding part FP may not be penetrated through by the primary etching. After the primary etching, the second acid-resistant film ARF2 may be removed.

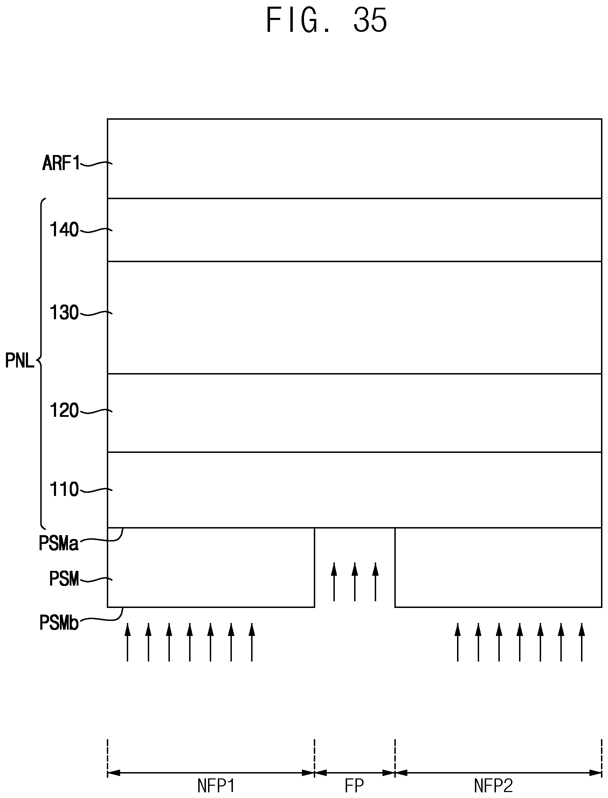

Referring to FIG. 35, thereafter, the preliminary support member PSM may be secondarily etched (slimmed). When the secondary etching is performed, the entire preliminary support member PSM may be uniformly etched. In other words, an etching thickness of the preliminary support member PSM during the secondary etching may be substantially uniform over the entire preliminary support member PSM.

The preliminary support member PSM may include a first surface PSMa and a second surface PSMb. The first surface PSMa may be adjacent to the circuit element layer 110, and the second surface PSMb may be opposite to the first surface PSMa. The slimming of the preliminary support member PSM may be a process of slimming the second surface PSMb.

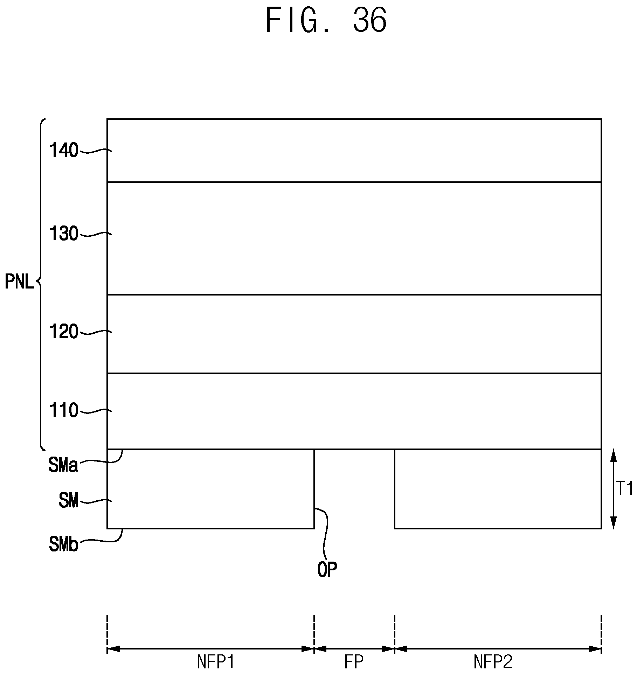

Referring further to FIG. 36, the first acid-resistant film ARF1 may be removed.

According to one embodiment, the entire preliminary support member PSM may be thinned through the secondary etching. Therefore, a thickness T1 of each of the first non-folding part NFP1 and the second non-folding part NFP2 may be in a range of about 0.15 T (i.e., 0.15 mm) to about 0.2 T (i.e., 0.2 mm). A thickness T1" of each of the first non-folding part NFP1 and the second non-folding part NFP2 after the primary etching, e.g., see FIG. 34, may be substantially equal to a thickness T1' of each of the first non-folding part NFP1 and the second non-folding part NFP2 before the primary etching, e.g., see FIG. 23.

In addition, a thickness T1 of each of the first non-folding part NFP1 and the second non-folding part NFP2 after the secondary etching, e.g., see FIG. 36, may be smaller than the thickness T1" of each of the first non-folding part NFP1 and the second non-folding part NFP2 after the primary etching, e.g., see FIG. 34.

In addition, the folding part FP may be penetrated through by the secondary etching so that an opening OP may be formed. Therefore, a thickness of the folding part FP after the secondary etching may be smaller than a thickness of the folding part FP after the primary etching.

Therefore, through the primary etching and the secondary etching, the opening OP may be formed in the folding part FP, and the thickness of each of the first non-folding part NFP1 and the second non-folding part NFP2 may be reduced.

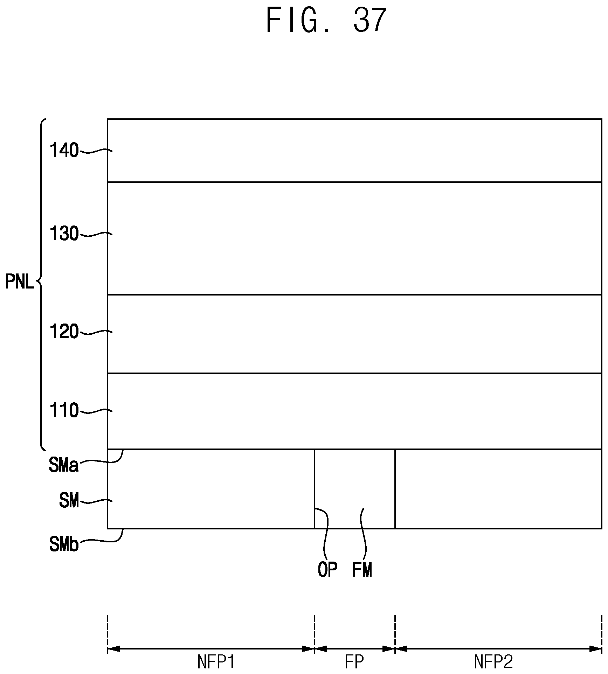

Referring to FIG. 37, a filling material FM may fill the folding part FP. The filling material FM may be formed of a silicon-based resin.

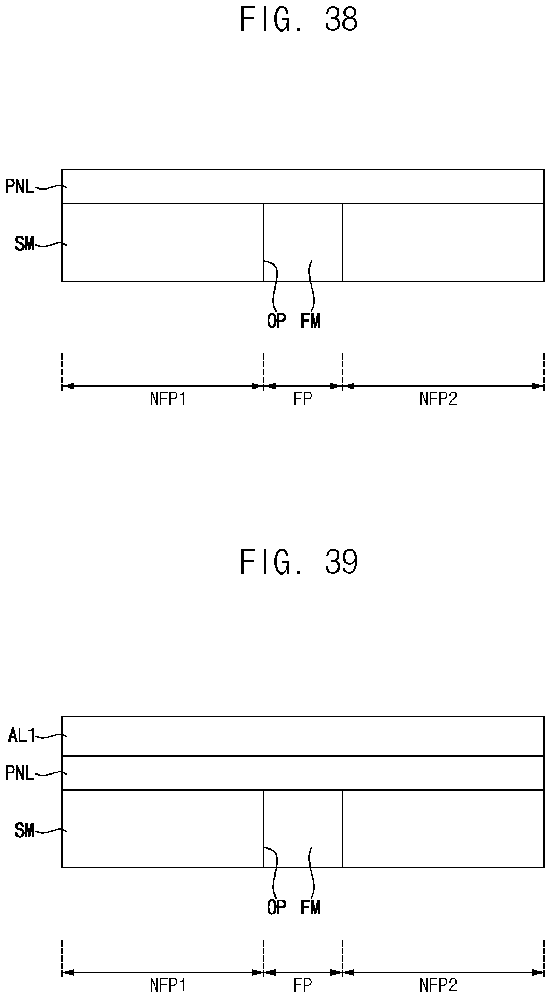

Referring to FIGS. 38 and 39, a first adhesive layer AL1 may be formed on the touch sensing layer 140. In other words, the first adhesive layer AL1 may be formed on the display panel PNL.

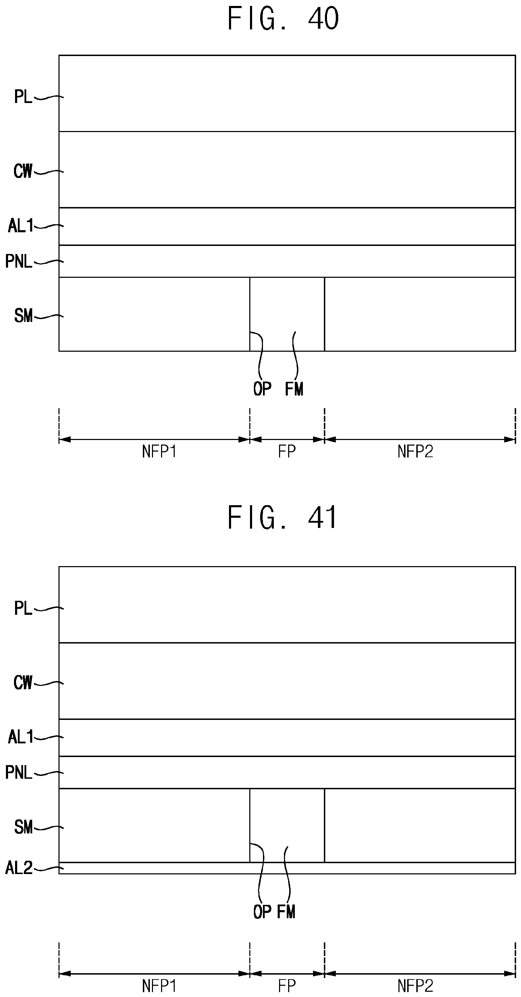

Referring to FIG. 40, a cover window CW may be formed on the first adhesive layer AL1. A protective film PL may be formed on the cover window CW. The cover window CW may include ultra-thin film tempered glass (Ultra-Thin Glass; UTG). Ultra-thin film glass may be strengthened into the ultra-thin film tempered glass through a strengthening process. For example, the ultra-thin film glass of the cover window CW may become tempered glass through chemical strengthening.

The cover window CW and the protective film PL may be coupled to each other through a thermal compression process. In other words, bonding strength may be formed between the cover window CW and the protective film PL through the thermal compression process.

Referring to FIG. 41, a second adhesive layer AL2 may be formed under the support member SM. The second adhesive layer AL2 may couple a lower module to the support member SM.

According to one embodiment, the support member SM may be formed by the primary etching process and the secondary etching process, and the circuit element layer 110 may be formed directly on the support member SM. Therefore, a carrier substrate to be removed during a manufacturing process of the display device may be prevented from being separately required, so that the manufacturing process of the display device may be simplified. In addition, the preliminary support member PSM may be slimmed to form the support member SM, so that a thickness of the display device may be reduced.

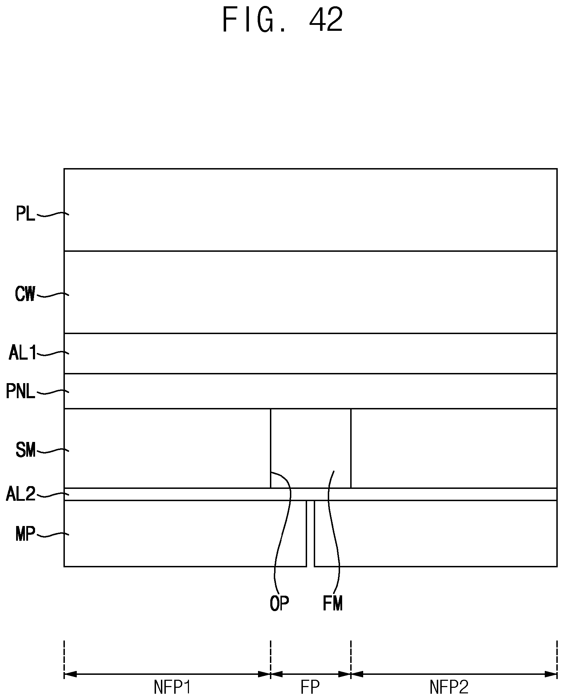

FIG. 42 is a sectional view showing a method for manufacturing a display device according to an embodiment of the present invention.

For example, a method for manufacturing a display device that will be described with reference to FIG. 42 may be a method for manufacturing the display device 12 of FIG. 21.

Referring further to FIG. 42, a metal plate MP may be formed under the second adhesive layer AL2. The metal plate MP may be coupled to the support member SM through the second adhesive layer AL2.

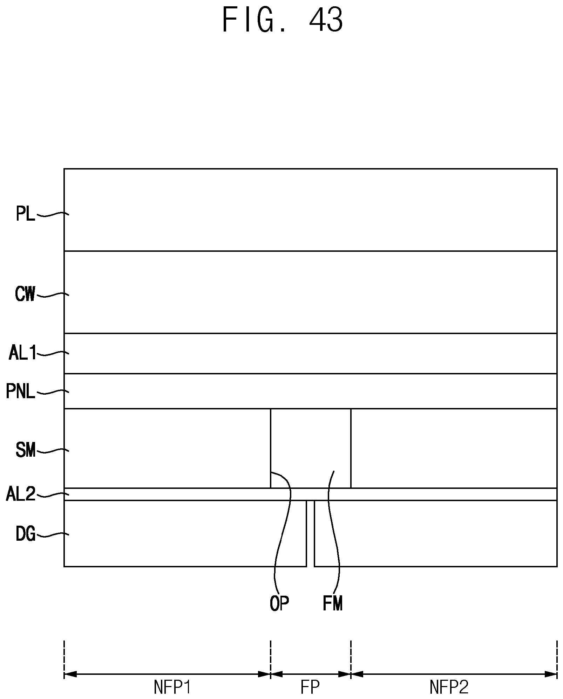

FIG. 43 is a sectional view showing another example of FIG. 42.

For example, a method for manufacturing a display device that will be described with reference to FIG. 43 may be a method for manufacturing the display device 13 of FIG. 22.

Referring further to FIG. 43, a digitizer DG may be formed under the second adhesive layer AL2. The digitizer DG may be coupled to the support member SM through the second adhesive layer AL2.

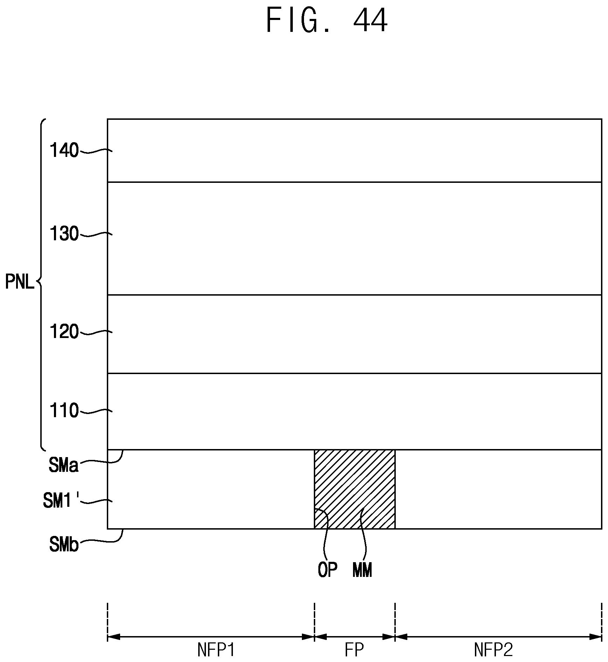

FIG. 44 is a sectional view showing another example of FIG. 37.

Referring to FIG. 44, a metal member MM may be formed in a folding part FP included in a support member SM1'. The metal member MM may be formed of a metal. For example, the metal member MM may be formed of stainless steel.

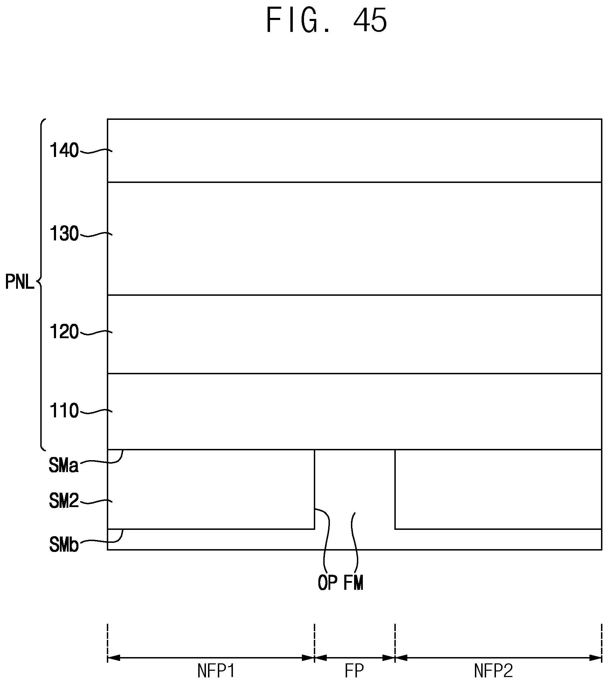

FIG. 45 is a sectional view showing still another example of FIG. 37.

Referring to FIG. 45, the filling material FM may fill the folding part FP, and may be further formed under the first non-folding part NFP1 and the second non-folding part NFP2. In other words, the filling material FM may overlap a lower portion of a support member SM2.

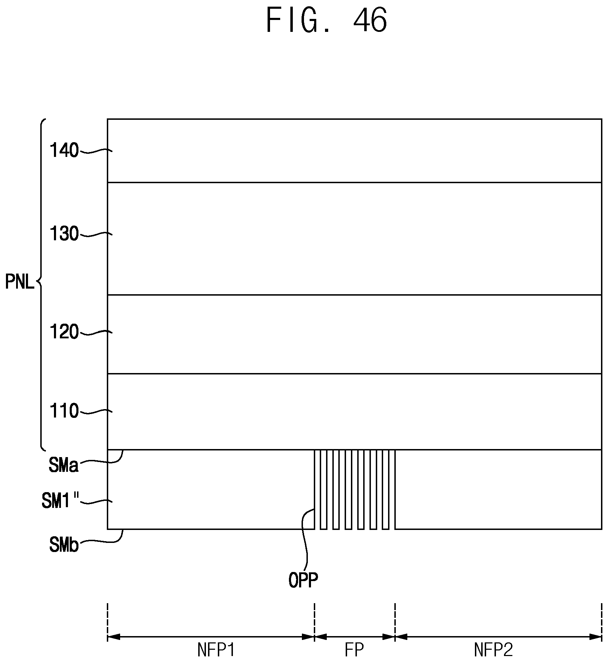

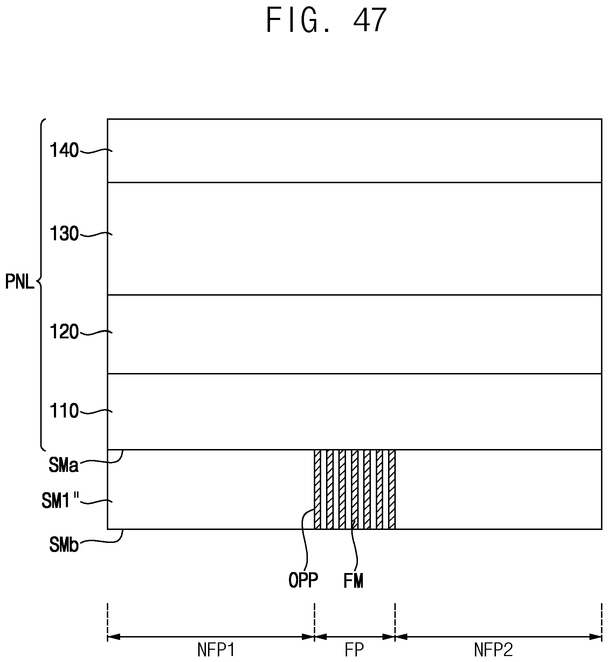

FIGS. 46 and 47 are sectional views showing another example of FIGS. 36 and 37.

Referring to FIG. 46, an opening pattern OPP may be formed in a folding part FP included in a support member SM1". The opening pattern OPP may include a plurality of openings. Each of the openings included in the opening pattern OPP may have one of a rectangular shape, a rhombic shape, an elliptical shape, a corrugated shape, and a rectangular shape with rounded corners.

Referring further to FIG. 47, the filling material FM may fill the opening pattern OPP. As another example, the filling material FM may fill the opening pattern OPP, and may be further formed under the first non-folding part NFP1 and the second non-folding part NFP2. In other words, the filling material FM may overlap a lower portion of a support member SM1", e.g., see FIG. 15.

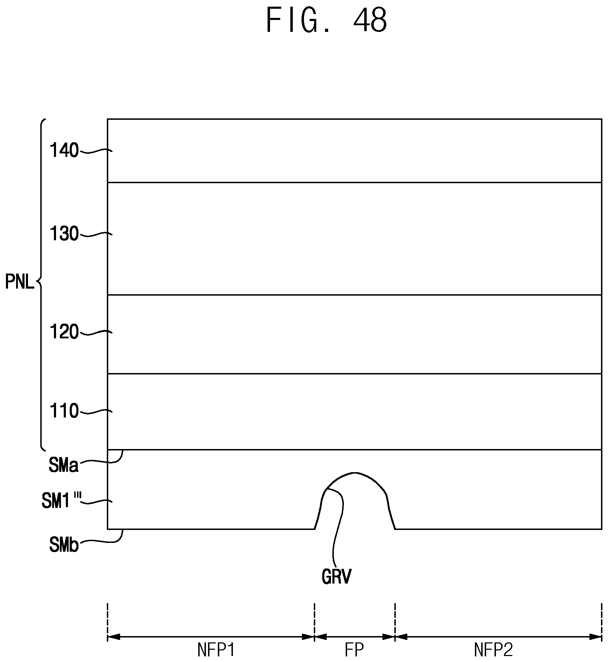

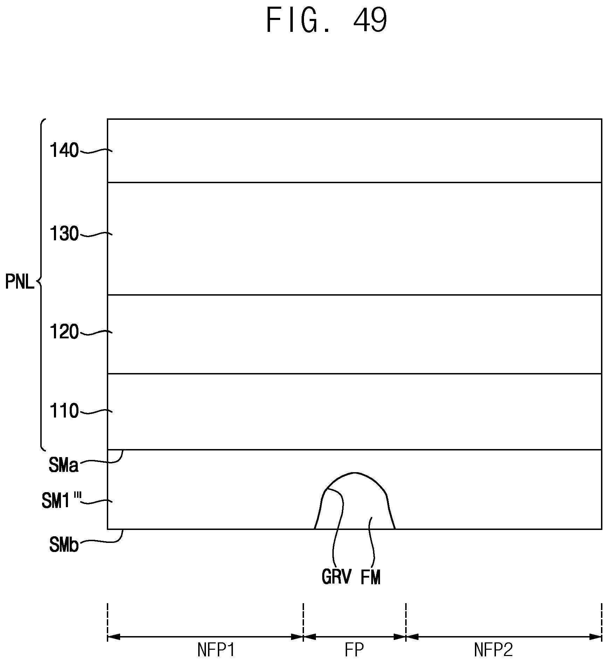

FIGS. 48 and 49 are sectional views showing still another example of FIGS. 36 and 37.

Referring to FIG. 48, a groove GRV may be formed in the folding part FP. The groove GRV may be formed on a second surface SMb of a support member SM1‴. Referring further to FIG. 49, the filling material FM may fill the groove GRV. As another example, the filling material FM may fill the groove GRV, and may be further formed under the first non-folding part NFP1 and the second non-folding part NFP2. In other words, the filling material FM may overlap a lower portion of the support member SM1‴, e.g., see FIG. 18.

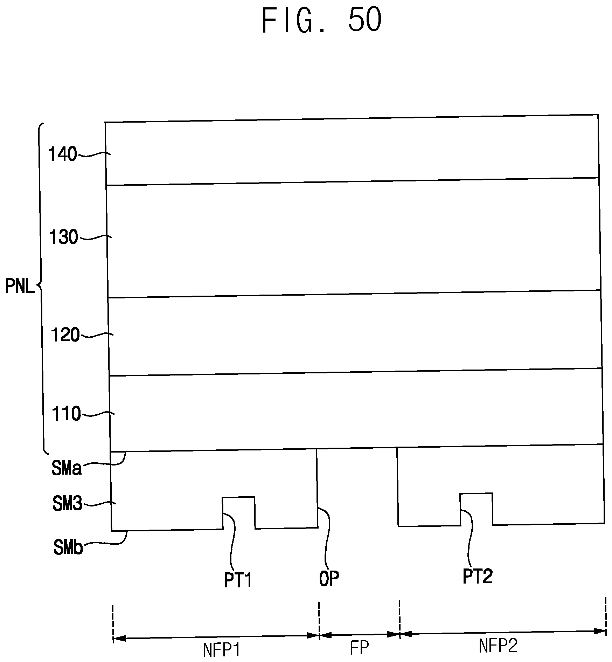

FIG. 50 is a sectional view showing another example of FIG. 36.

Referring to FIG. 50, a first pattern PT1 that is adjacent to the folding part FP may be formed in the first non-folding part NFP1. A second pattern PT2 that is adjacent to the folding part FP may be formed in the second non-folding part NFP2. The first pattern PT1 and the second pattern PT2 may be formed on a second surface SMb of a support member SM3. Each of the first pattern PT1 and the second pattern PT2 may be formed in a groove shape.

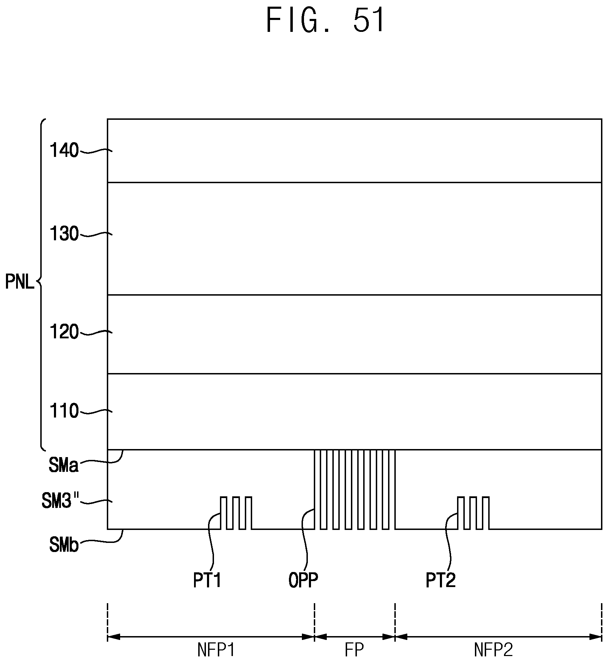

FIG. 51 is a sectional view showing another example of FIG. 46.

Referring to FIG. 51, a first pattern PT1 that is adjacent to the folding part FP may be formed in the first non-folding part NFP1. A second pattern PT2 that is adjacent to the folding part FP may be formed in the second non-folding part NFP2. The first pattern PT1 and the second pattern PT2 may be formed on a second surface SMb of a support member SM3". Each of the first pattern PT1 and the second pattern PT2 may be formed in an opening pattern shape.

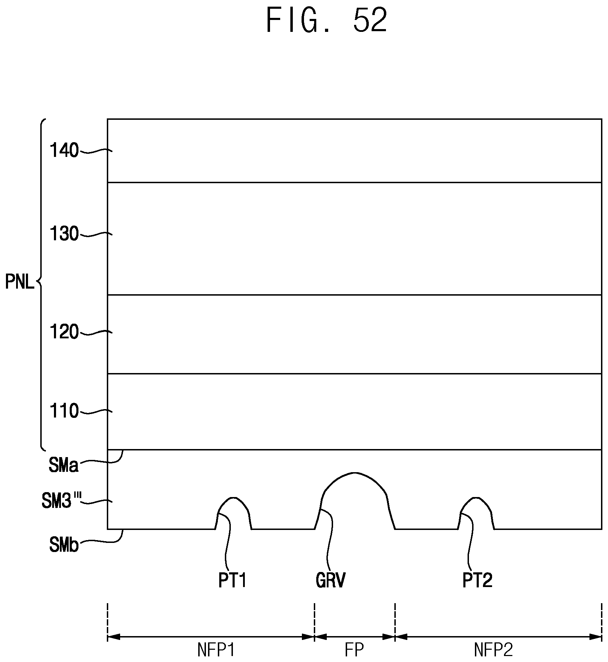

FIG. 52 is a sectional view showing another example of FIG. 48.

Referring to FIG. 52, a first pattern PT1 that is adjacent to the folding part FP may be formed in the first non-folding part NFP1. A second pattern PT2 that is adjacent to the folding part FP may be formed in the second non-folding part NFP2. The first pattern PT1 and the second pattern PT2 may be formed on a second surface SMb of a support member SM3"'. Each of the first pattern PT1 and the second pattern PT2 may be formed in a groove shape.

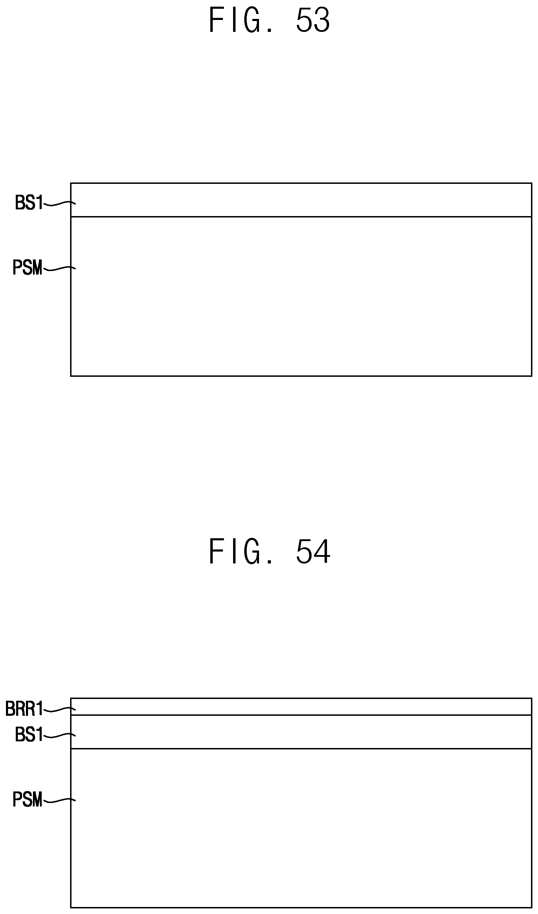

FIGS. 53 to 57 are views for describing a method for manufacturing a display device according to an embodiment of the present invention.

A method for manufacturing a display device that will be described with reference to FIGS. 53 to 57 may be a method for manufacturing the display device 11 of FIG. 20.

Referring to FIG. 53, a first base substrate BS1 may be formed on the preliminary support member PSM. The first base substrate BS1 may be formed of polyimide. A thickness of the first base substrate BS1 may be in a range of about 56,000 angstroms to about 100,000 angstroms.

Referring to FIG. 54, a first barrier layer BRR1 may be formed on the first base substrate BS1. The first barrier layer BRR1 may be formed of silicon oxide. A thickness of the first barrier layer BRR1 may be smaller than the thickness of the first base substrate BS1.

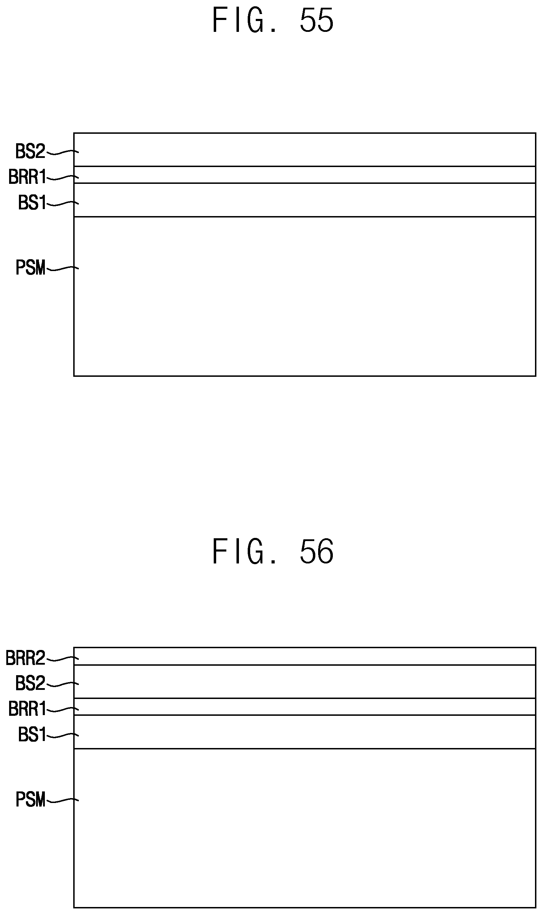

Referring to FIG. 55, a second base substrate BS2 may be formed on the first barrier layer BRR1. The second base substrate BS2 may be formed of polyimide. A thickness of the second base substrate BS2 may be in a range of about 56,000 angstroms to about 100,000 angstroms.

Referring to FIG. 56, a second barrier layer BRR2 may be formed on the second base substrate BS2. The second barrier layer BRR2 may be formed of silicon oxide. A thickness of the second barrier layer BRR2 may be smaller than the thickness of the second base substrate BS2.

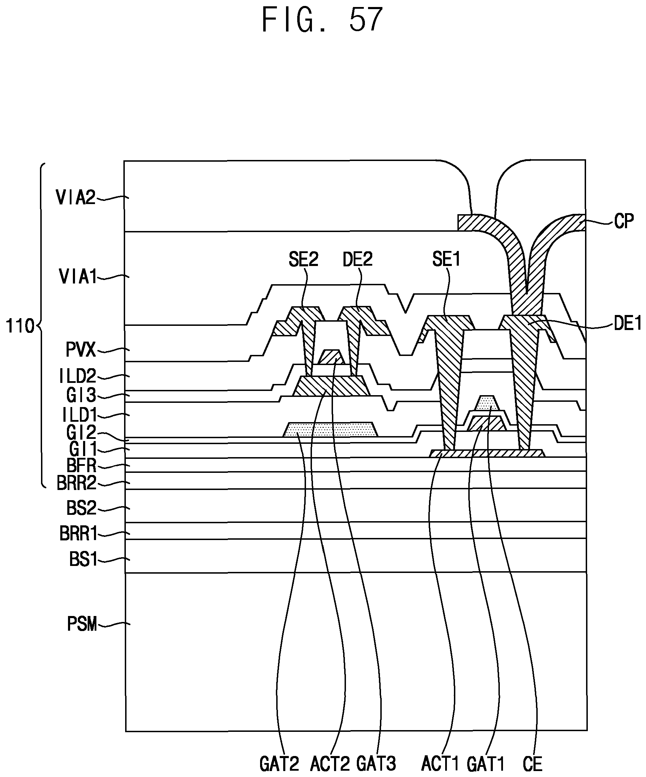

Referring to FIG. 57, after the second base substrate BS2 is formed, the circuit element layer 110 may be formed on the second base substrate BS2, starting with the second barrier layer BRR2.

According to one embodiment, the first base substrate BS1, the first barrier layer BRR1, and the second base substrate BS2 may be further formed between the support member SM and the circuit element layer 110, so that moisture may be effectively prevented from penetrating from the outside.

### [Industrial Applicability]

Display devices according to exemplary embodiments of the present invention may be applied to display devices included in a computer, a laptop computer, a mobile phone, a smart phone, a smart pad, a vehicle, a PMP, a PDA, an MP3 player, and the like.

Although the embodiments of the present invention have been described above, it will be understood by those of ordinary skill in the art that various changes and modifications can be made to the present invention without departing from the idea and scope of the present invention as set forth in the appended claims.

### <Explanation of Reference Number>

| | | | |
|---|---|---|---|
| 10: | display device | SM: | support member |
| PNL: | display panel | AL1: | first adhesive layer |
| AL2: | second adhesive layer | CW: | cover window |
| PL: | protective film | FM: | filling material |
| NFP1: | first non-folding part | NFP2: | second non-folding part |
| FP: | folding part | OP: | opening |
| OPP: | opening pattern | GRV: | groove |
| PT1: | first pattern | PT2: | second pattern |
| 110: | circuit element layer | 120: | light emitting element layer |
| 130: | encapsulation layer | 140: | touch sensing layer |
| MP: | metal plate | DG: | digitizer |
| MM: | metal member | BS1: | first base substrate |
| BS2: | second base substrate | BRR1: | first barrier layer |
| BRR2: | second barrier layer | | |

## Claims

1. A display device comprising:
a support member including a first non-folding part including a glass, a second non-folding part including the glass, and a folding part disposed between the first non-folding part and the second non-folding part;
a circuit element layer disposed on the support member, and including at least one transistor;
a light emitting element layer disposed on the circuit element layer, and including at least one light emitting diode;
an encapsulation layer disposed on the light emitting element layer, and including at least one of an organic encapsulation layer and an inorganic encapsulation layer;
a touch sensing layer disposed on the encapsulation layer, and including at least one touch electrode;
a first adhesive layer disposed on the touch sensing layer;
a cover window disposed on the first adhesive layer;
a protective film disposed on the cover window; and
a second adhesive layer disposed on the support member.

2. The display device of claim 1, wherein an opening is defined in the folding part.

3. The display device of claim 2, further comprising a filling material overlapping the folding part,
wherein the filling material fills the opening.

4. The display device of claim 3, wherein the filling material is further disposed on the first non-folding part and the second non-folding part.

5. The display device of claim 2, further comprising a metal member overlapping the folding part,
wherein the metal member fills the opening.

6. The display device of claim 5, wherein the metal member includes stainless steel.

7. The display device of claim 1, wherein an opening pattern is defined in the folding part.

8. The display device of claim 7, wherein each of a plurality of openings included in the opening pattern has one of a rectangular shape, a rhombic shape, an elliptical shape, a corrugated shape, and a rectangular shape with rounded corners.

9. The display device of claim 7, further comprising a filling material overlapping the folding part,
wherein the filling material fills the opening pattern.

10. The display device of claim 9, wherein the filling material is further disposed on the first non-folding part and the second non-folding part.

11. The display device of claim 1, wherein a groove is defined in the folding part.

12. The display device of claim 11, further comprising a filling material overlapping the folding part,
wherein the filling material fills the groove.

13. The display device of claim 12, wherein the filling material is further disposed on the first non-folding part and the second non-folding part.

14. The display device of claim 1, wherein a thickness of the support member is in a range of 0.15 mm to 0.2 mm.

15. The display device of claim 1, wherein the cover window includes ultra-thin tempered glass.

16. The display device of claim 1, further comprising:
a first base substrate disposed between the support member and the circuit element layer;
a first barrier layer disposed on the first base substrate; and
a second base substrate disposed on the first barrier layer.

17. The display device of claim 16, wherein each of the first base substrate and the second base substrate includes polyimide.

18. The display device of claim 16, wherein the first barrier layer includes silicon oxide.

19. The display device of claim 16, wherein a thickness of each of the first base substrate and the second base substrate is in a range of 56,000 angstroms to 100,000 angstroms.

20. The display device of claim 1, wherein the circuit element layer includes:
a first active layer disposed on the support member; and
a second active layer disposed on the first active layer.

21. The display device of claim 20, wherein the first active layer includes a silicon semiconductor, and
the second active layer includes an oxide semiconductor.

22. The display device of claim 1, further comprising a metal plate disposed on the second adhesive layer.

23. The display device of claim 1, further comprising a digitizer disposed on the second adhesive layer.

24. The display device of claim 1, wherein the first non-folding part further includes a first pattern that is adjacent to the folding part, and
the second non-folding part further includes a second pattern that is adjacent to the folding part.

25. The display device of claim 24, wherein the support member includes a first surface that is adjacent to the circuit element layer, and a second surface that is opposite to the first surface, and
each of the first pattern and the second pattern is defined on the second surface of the support member.

26. The display device of claim 24, wherein a height of each of the first pattern and the second pattern is smaller than a height of the folding part, and
a width of each of the first pattern and the second pattern is smaller than a width of the folding part.

27. The display device of claim 24, wherein each of the first pattern and the second pattern includes an opening pattern or a groove.

28. The display device of claim **1,** wherein the circuit element layer includes a barrier layer disposed on the support member and making contact with the support member.

29. The display device of claim 28, wherein the barrier layer includes silicon oxide.

30. A method for manufacturing a display device, the method comprising:
forming a preliminary support member including a glass;
forming a circuit element layer on the preliminary support member;
forming a light emitting element layer on the circuit element layer;
forming an encapsulation layer on the light emitting element layer;
forming a touch sensing layer on the encapsulation layer;
forming a support member by forming a folding part by patterning a portion of the preliminary support member, and forming a first non-folding part and a second non-folding part, which are adjacent to each other with the folding part interposed between the first non-folding part and the second non-folding part, by thinning the entire preliminary support member;
forming a first adhesive layer on the touch sensing layer;
forming a cover window on the first adhesive layer;
forming a protective film on the cover window; and
forming a second adhesive layer on the support member.

31. The method of claim 30, wherein the preliminary support member includes a first surface that is adjacent to the circuit element layer, and a second surface that is opposite to the first surface, and
the thinning of the preliminary support member includes thinning the second surface of the preliminary support member.

32. The method of claim 30, wherein the forming of the support member is performed after the forming of the touch sensing layer.

33. The method of claim 32, wherein the forming of the support member includes:
attaching a first acid-resistant film onto the touch sensing layer;
attaching a second acid-resistant film onto the preliminary support member;
patterning a portion of the second acid-resistant film overlapping the folding part;
primarily etching the preliminary support member;
removing the second acid-resistant film;
secondarily etching the preliminary support member; and
removing the first acid-resistant film.

34. The method of claim 33, wherein the primarily etching of the preliminary support member includes partially etching a portion of the folding part overlapping the patterned portion of the second acid-resistant film.

35. The method of claim 34, wherein the secondarily etching of the preliminary support member includes forming the support member by etching the entire preliminary support member.

36. The method of claim 35, wherein a thickness of the folding part after the secondarily etching is smaller than a thickness of the folding part after the primarily etching.

37. The method of claim 35, wherein a thickness of each of the first non-folding part and the second non-folding part after the secondarily etching is smaller than a thickness of each of the first non-folding part and the second non-folding part after the primarily etching.

38. The method of claim 30, wherein the forming of the folding part includes forming an opening in the folding part.

39. The method of claim 30, wherein the forming of the folding part includes forming an opening pattern in the folding part.

40. The method of claim 30, wherein the forming of the folding part includes forming a groove in the folding part.

41. The method of claim 30, further comprising filling the folding part with a filling material.

42. The method of claim 41, wherein the filling material is further formed on the first non-folding part and the second non-folding part.

43. The method of claim 30, further comprising forming a metal member in the folding part.

44. The method of claim 43, wherein the metal member is formed of stainless steel.

45. The method of claim 30, wherein a thickness of the preliminary support member is in a range of 0.4 mm to 0.5 mm.

46. The method of claim 30, wherein a thickness of each of the first non-folding part and the second non-folding part included in the support member is in a range of 0.15 mm to 0.2 mm.

47. The method of claim 30, wherein, before the forming of the circuit element layer, the method further comprises:
forming a first base substrate on the preliminary support member;
forming a first barrier layer on the first base substrate; and
forming a second base substrate on the first barrier layer.

48. The method of claim 47, wherein each of the first base substrate and the second base substrate is formed of polyimide.

49. The method of claim 47, wherein the first barrier layer is formed of silicon oxide.

50. The method of claim 30, further comprising forming a metal plate on the second adhesive layer.

51. The method of claim 30, further comprising forming a digitizer on the second adhesive layer.

52. The method of claim 30, wherein the forming of the support member includes:
forming a first pattern, which is adjacent to the folding part, in the first non-folding part; and
forming a second pattern, which is adjacent to the folding part, in the second non-folding part.

53. The method of claim 30, wherein the forming of the circuit element layer includes forming a barrier layer making contact with the preliminary support member on the preliminary support member.
